(19) Europäisches Patentamt
European Patent Office
Office européen des brevets

(11) **EP 3 076 450 A1**

(12) **EUROPEAN PATENT APPLICATION**

(43) Date of publication:
**05.10.2016 Bulletin 2016/40**

(51) Int Cl.:
**H01L 49/02** (2006.01)

(21) Application number: **16163266.6**

(22) Date of filing: **31.03.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.03.2015   JP 2015073872**
          **31.03.2015   JP 2015073886**
          **31.03.2015   JP 2015073957**

(71) Applicant: **TDK Corporation**
**Tokyo 108-0023 (JP)**

(72) Inventors:
• EHARA, Shinji
  Minato-ku,, Tokyo 108-0023 (JP)
• ONODERA, Ikuhito
  Minato-ku,, Tokyo 108-0023 (JP)
• WAKATA, Eiko
  Minato-ku,, Tokyo 108-0023 (JP)
• OSANAI, Katsunori
  Minato-ku,, Tokyo 108-0023 (JP)
• TANIGUCHI, Masamichi
  Minato-ku,, Tokyo 108-0023 (JP)

(74) Representative: **Epping - Hermann - Fischer**
**Patentanwaltsgesellschaft mbH**
**Schloßschmidstraße 5**
**80639 München (DE)**

(54) **THIN FILM CAPACITOR**

(57)     A lower electrode (4) can have an uneven surface structure. An upper electrode (6) can also have the uneven surface structure. A projecting portion of the upper electrode (6) projecting to the lower electrode side is positioned in a gap between projecting portions of the lower electrode (4) and the lower electrode (4) includes Cu as a main component. Young's moduli of a substrate (1), a stress adjustment layer (2), and the lower electrode (4) have a specific relation. Also, corner portions of radii (R1) of curvature positioned inside a projecting portion (4b) have a specific relation.

*Fig.1*

1      **EP 3 076 450 A1**      2

## Description

### TECHNICAL FIELD

The present invention relates to a thin film capacitor in which a vertical cross section has an uneven structure.

### BACKGROUND

A thin film capacitor serving as an electronic component is disclosed in, for example, Patent Literature 1 (Japanese Unexamined Patent Publication No. 2002-26266). Also, a trench capacitor having a three-dimensional structure so that a surface area per unit area increases in semiconductor integration technology is proposed as a structure for achieving a capacitor constituting a memory with high capacity (Patent Literature 2: Specification of U.S. Patent No. 6,740,922). Also, there has been an attempt to apply this three-dimensional structure to electronic components other than memories (Patent Literature 3: Japanese Unexamined Patent Publication No. H6-325970).

### SUMMARY

However, characteristics of a thin film capacitor may easily deteriorate in a thin film capacitor having a size reduced by providing an uneven surface structure as an electronic component. The present invention has been made in view of this problem and an objective of the invention is to provide a thin film capacitor capable of suppressing characteristic deterioration.

In a first type of thin film capacitor, a lower electrode has an uneven surface structure of a vertical cross section in a thickness direction (Z) of a substrate, an upper electrode has an uneven surface structure of a vertical cross section in the thickness direction of the substrate, a projecting portion of the upper electrode projecting to a lower electrode side is positioned in a gap between projecting portions of the lower electrode, the lower electrode includes Cu as a main component, and a Young's modulus $E_{SS}$ of the substrate 1, a Young's modulus $E_{SC}$ of a stress adjustment layer, and a Young's modulus $E_{LE}$ of the lower electrode satisfy the relational expressions $E_{LE} < E_{SC}$ and $Ess < E_{SC}$.

In a second type of thin film capacitor, the distal end of the projecting portion of the lower electrode has corner portions of radii R1 of curvature for which centers C1a and C1b of curvature are positioned inside the projecting portion. Here, the radius R1 of curvature and a thickness td of a dielectric thin film satisfy the relational expression $0.4 \times td \le R1 \le 20xtd$. When the radius R1 of curvature is less than 0.4 times the thickness td of the dielectric thin film, the antenna effect increases and an electric field is concentrated on the dielectric thin film, and an internal defect of the dielectric thin film occurs while an element is used. When the radius R1 of curvature is greater than 20 times the thickness td of the dielectric thin film, the antenna effect is degraded, but malfunctions such as concentration of an electric field due to a crystalline grain boundary of the electrode occurring in the corner portion occur.

In a third type of thin film capacitor, the thin film capacitor in which a dielectric thin film is interposed between a lower electrode and an upper electrode includes a first terminal provided in the lower electrode and a second terminal provided in the upper electrode, wherein the lower electrode has an uneven surface structure. A ridge line of the projecting portion of the uneven surface structure extends in a direction (X-axis direction) from the first terminal to the second terminal. In this case, equivalent series resistance (ESR) of the X-axis direction decreases and therefore the loss of the thin film capacitor decreases and stability increases.

### BRIEF DESCRIPTION OF THE DRAWINGS

FIG. 1 is a diagram illustrating a vertical cross-sectional configuration of a thin film capacitor according to an embodiment.
FIGS. 2A, 2B, 2C, 2D, 2E, 2F, 2G, 2H, and 2I are diagrams illustrating a process of manufacturing the thin film capacitor.
FIGS. 3A, 3B, and 3C are plan views of various lower electrodes and dummy electrodes.
FIGS. 4A, 4B, and 4C are plan views of various upper electrodes and lower contact electrodes.
FIG. 5 is an exploded perspective view of the thin film capacitor.
FIG. 6 is a diagram illustrating a vertical cross-sectional configuration of the thin film capacitor according to a modified embodiment.
FIG. 7 is a chart illustrating parameters of materials.
FIG. 8 is a chart illustrating experiment conditions of Young's moduli in experiment examples (embodiments and comparative examples).
FIG. 9 is a chart illustrating relations of linear expansion coefficients in experiment examples (embodiments and comparative examples).
FIG. 10 is a chart illustrating relations of heat conductivity in experiment examples (embodiments and comparative examples).
FIG. 11 is a chart illustrating the number of normal products after an environmental test is performed on samples of the above-described experiment examples (embodiments and comparative examples).
FIG. 12 is a diagram illustrating a vertical cross-sectional configuration (XZ plane) of a thin film capacitor according to an embodiment.
FIGS. 13A, 13B, 13C, 13D, 13E, 13F, 13G, 13H, and 13I are diagrams illustrating a cross-sectional configuration (XZ plane) of a thin film capacitor for describing a process of manufacturing a thin film ca-

2

pacitor.

FIGS. 14A, 14B, and 14C are plan views of various lower electrodes and dummy electrodes.

FIGS. 15A, 15B, and 15C are plan views of various upper electrodes and lower contact electrodes.

FIG. 16 is an exploded perspective view of a thin film capacitor.

FIG. 17 is a diagram illustrating a vertical cross-sectional configuration of the thin film capacitor according to a modified embodiment.

FIGS. 18A, 18B, and 18C are diagrams illustrating a cross-sectional configuration (XZ plane) of a thin film capacitor for describing a process of rounding a corner portion of a distal end of a projecting portion of the lower electrode.

FIG. 19 is a diagram illustrating a cross-sectional configuration (XZ plane) of the projecting portion of the lower electrode.

FIGS. 20A, 20B, and 20C are diagrams illustrating a cross-sectional configuration (XZ plane) of a thin film capacitor for describing a process of rounding corner portions of a distal end and a proximal end of a projecting portion of the lower electrode.

FIG. 21 is a diagram illustrating a cross-sectional configuration (XZ plane) of the projecting portion of the lower electrode.

FIG. 22 is a diagram illustrating a cross-sectional configuration (YZ plane) of the projecting portion of the lower electrode.

FIG. 23 is a chart illustrating a relation between a shape of a corner portion and an evaluation result in an embodiment and a comparative example.

FIG. 24 is a diagram illustrating a vertical cross-sectional configuration (XZ plane) of a thin film capacitor according to an embodiment.

FIGS. 25A, 25B, 25C, 25D, 25E, 25F, 25G, 25H, and 25I are diagrams illustrating a cross-sectional configuration (XZ plane) for describing a process of manufacturing a thin film capacitor.

FIGS. 26A, 26B, and 26C are plan views of various lower electrodes and dummy electrodes.

FIGS. 27A, 27B, and 27C are plan views of various upper electrodes and lower contact electrodes.

FIG. 28 is an exploded perspective view of a thin film capacitor.

FIG. 29 is a diagram illustrating a vertical cross-sectional configuration of the thin film capacitor according to a modified embodiment.

FIG. 30 is a diagram illustrating a vertical cross-sectional configuration (YZ plane) of the thin film capacitor according to an embodiment.

FIG. 31A is a plan view of a lower electrode and a dummy electrode in a comparative example.

FIG. 31B is a plan view of an upper electrode and a lower contact electrode.

FIG. 32 is a diagram illustrating an example in which a vertical cross-sectional structure (which is the same as a structure of an upper electrode) in a YZ plane of the projecting portion of the lower electrode has a tapered shape.

## DETAILED DESCRIPTION

First, an overview of a first type of invention will be described.

In the first type of invention, a thin film capacitor of a first aspect is a thin film capacitor including: a substrate; a stress adjustment layer formed on a main surface of the substrate; a lower electrode formed on the stress adjustment layer; a dielectric thin film configured to cover the lower electrode; and an upper electrode formed on the dielectric thin film, wherein the lower electrode has an uneven surface structure of a vertical cross section in a thickness direction of the substrate, wherein the upper electrode has an uneven surface structure of a vertical cross section in a thickness direction of the substrate, wherein a projecting portion of the upper electrode projecting to a lower electrode side is positioned in a gap between projecting portions of the lower electrode, wherein the lower electrode includes Cu as a main component, and wherein a Young's modulus Ess of the substrate, a Young's modulus $E_{SC}$ of the stress adjustment layer, and a Young's modulus $E_{LE}$ of the lower electrode satisfy the relational expressions $E_{LE} < E_{SC}$ and Ess $< E_{SC}$.

According to this thin film capacitor, the deformation of the lower electrode is suppressed because the stress adjustment layer is harder (has a higher Young's modulus) than the lower electrode and the substrate for supporting the lower electrode among the above-described three elements, and thus the damage associated with the deformation of the dielectric thin film adjacent to the lower electrode, and the characteristic deterioration associated with the damage can be suppressed.

In the thin film capacitor of a second aspect, a linear expansion coefficient $\alpha_{SS}$ of the substrate, a linear expansion coefficient $\alpha_{SC}$ of the stress adjustment layer, and a linear expansion coefficient $\alpha_{LE}$ of the lower electrode satisfy the relational expressions $\alpha_{SC} < \alpha_{LE}$ and $\alpha_{SC} < \alpha_{SS}$.

In this case, because thermal expansion of the substrate or the lower electrode is suppressed due to a decrease in the linear expansion coefficient of the stress adjustment layer even when thermal expansion occurs in the substrate or the lower electrode, the deformation of the lower electrode due to a change in a temperature decreases and the damage of the dielectric thin film adjacent to the substrate or the lower electrode and the characteristic deterioration associated with the damage can be suppressed.

In the thin film capacitor of a third aspect, a heat conductivity $\lambda_{SS}$ of the substrate, a heat conductivity $\lambda_{SC}$ of the stress adjustment layer, and a heat conductivity $\lambda_{LE}$ of the lower electrode satisfy the relational expressions $\lambda_{SC} < \lambda_{SS}$ and $\lambda_{SC} < \lambda_{LE}$.

In this case, because the heat conductivity of the stress adjustment layer is small even when the change in the temperature occurs in the substrate or the lower electrode, the deformation of the lower electrode decreases due to the suppression of the heat conduction of the substrate and the lower electrode and the suppression of the occurrence of linear expansion and the damage of the dielectric thin film adjacent to the substrate and the lower electrode and the characteristic deterioration according to the damage can be suppressed. In particular, the effect tends to be large in terms of the fact that the change in the temperature in a substrate having a relatively large volume does not affect the lower electrode.

In the thin film capacitor of a fourth aspect, the lower electrode includes: a common electrode part extending in parallel to a main surface of the substrate; and a plurality of projecting portions extending to project away from the substrate from the common electrode part, the thin film capacitor includes: a protective film configured to cover the upper electrode; a dummy electrode formed on the stress adjustment layer; and a lower contact electrode formed on the common electrode part of the lower electrode, the dielectric thin film, the upper electrode, and a first connection electrode are positioned on the dummy electrode, the lower contact electrode in contact with the common electrode part and a second connection electrode are positioned on the common electrode part of the lower electrode via an opening provided in the dielectric thin film, the dummy electrode has the same thickness as the common electrode part of the lower electrode, the first connection electrode is positioned within a first contact hole provided in the protective film, and the second connection electrode is positioned within a second contact hole provided in the protective film.

In the case of this structure, because the dummy electrode has the same thickness as the common electrode part of the lower electrode, heights of the first connection electrode and the second connection electrode in the thickness direction can be approximately the same and the thin-film capacitor of a flat structure can be formed.

According to the thin film capacitor of these aspects, it is possible to suppress characteristic deterioration by providing the stress adjustment layer of a predetermined condition.

Hereinafter, the thin film capacitor according to the embodiment related to the first type of invention will be described. Also, the same reference signs are assigned to the same elements and redundant description thereof will be omitted. Also, an XYZ three-dimensional orthogonal coordinate system is set and the thickness direction of the substrate is assumed to be the Z-axis direction.

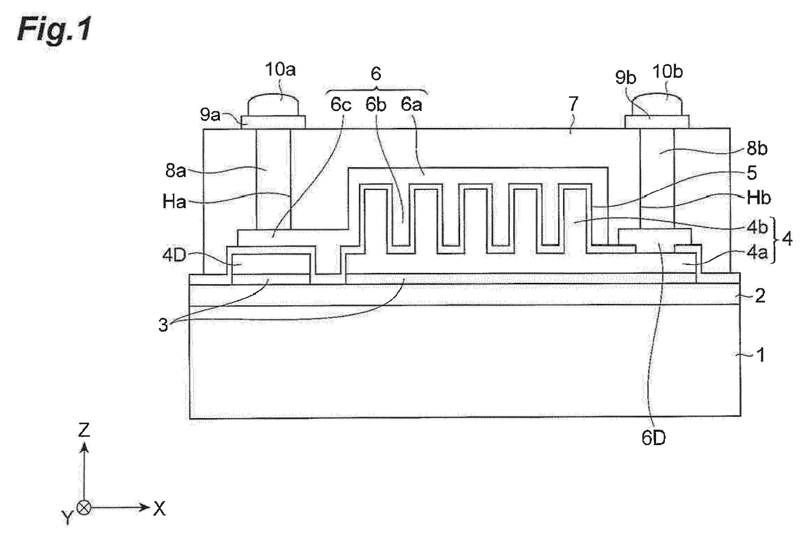

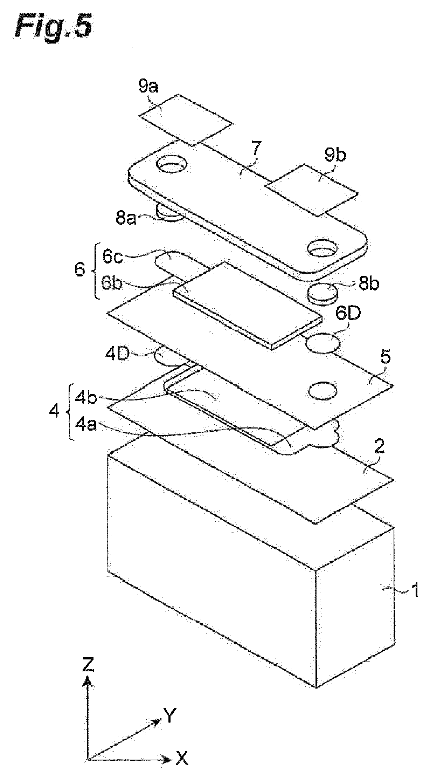

FIG. 1 is a diagram illustrating a vertical cross-sectional configuration of a thin film capacitor according to an embodiment. Also, FIG. 5 is an exploded perspective view of a thin film capacitor, but some parts such as a base layer and a protective film in FIG. 1 are omitted to clearly describe the structure. In the following description, FIGS. 1 and 5 will be appropriately referred to.

This thin film capacitor includes a substrate 1, a stress adjustment layer 2 formed on a main surface (XY plane) of the substrate 1, a lower electrode 4 formed on the stress adjustment layer 2 via a base layer 3, a dielectric thin film 5 configured to cover the lower electrode 4, and an upper electrode 6 formed on the dielectric thin film 5.

A main part of the thin film capacitor is constituted of the lower electrode 4, the upper electrode 6, and the dielectric thin film 5 positioned between the lower electrode 4 and the upper electrode 6.

The lower electrode 4 includes the common electrode part 4a extending in parallel to the main surface of the substrate 1 and a plurality of projecting portions 4b extending to project from the common electrode part 4a away from the substrate 1. Likewise, the upper electrode 6 includes a common electrode part 6a extending in parallel to the main surface of the substrate 1 and a plurality of projecting portions 6b extending to project from the common electrode part 6a toward the substrate 1. Also, the upper electrode 6 has a contact portion 6c for enabling the connection electrode to come in contact with an external terminal.

The lower electrode 4 has an uneven surface structure of a vertical cross section (XZ plane) in the thickness direction of the substrate 1 and has a comb tooth shape. Likewise, the upper electrode 6 has an uneven surface structure of a vertical cross section (XZ plane) in the thickness direction of the substrate 1 and has a comb tooth shape. The projecting portion 6b projecting to the lower electrode side of the upper electrode 6 is positioned in a gap between the projecting portions 4b of the lower electrode 4 and a structure in which comb teeth face each other and engaged with each other is a trench structure in the vertical cross section and increases capacitance per unit area.

This thin film capacitor includes a protective film 7 configured to cover the upper electrode 6, a dummy electrode 4D formed on the stress adjustment layer 2, and a lower contact electrode 6D formed on the common electrode part 4a of the lower electrode 4 and in contact with the common electrode part 4a. The dummy electrode 4D is formed simultaneously with the common electrode part 4a of the lower electrode and the lower contact electrode 6D is formed simultaneously with the upper electrode 6.

On the left in FIG. 1 or 5 of the thin film capacitor, the dielectric thin film 5, the contact portion 6c of the upper electrode 6, and a first connection electrode 8a are positioned on the dummy electrode 4D. On the other hand, on the right in FIG. 1 or 5 of the thin film capacitor, the lower contact electrode 6D in contact with the common electrode part 4a and a second connection electrode 8b are positioned on the common electrode part 4a of the lower electrode 4 via an opening provided in the dielectric thin film 5. The dummy electrode 4D has the same thickness as the common electrode part 4a of the lower electrode 4.

Also, the first connection electrode 8a is positioned within a first contact hole Ha provided in the protective film 7 and the second connection electrode 8b is positioned within a second contact hole Hb provided in the protective film 7.

In the case of this structure, because the dummy electrode 4D has the same thickness as the common electrode part 4a of the lower electrode 4, heights of the first connection electrode 8a and the second connection electrode 8b in the thickness direction can be approximately the same and a thin film capacitor of a flat structure can be formed.

A contact electrode and/or an under bump metal 9a are in contact with the first connection electrode 8a and are positioned on the first connection electrode 8a. A contact electrode and/or an under bump metal 9b are in contact with the second connection electrode 8b and are positioned on the second connection electrode 8b. Bumps 10a and 10b are arranged on the under bump metals 9a and 9b, respectively.

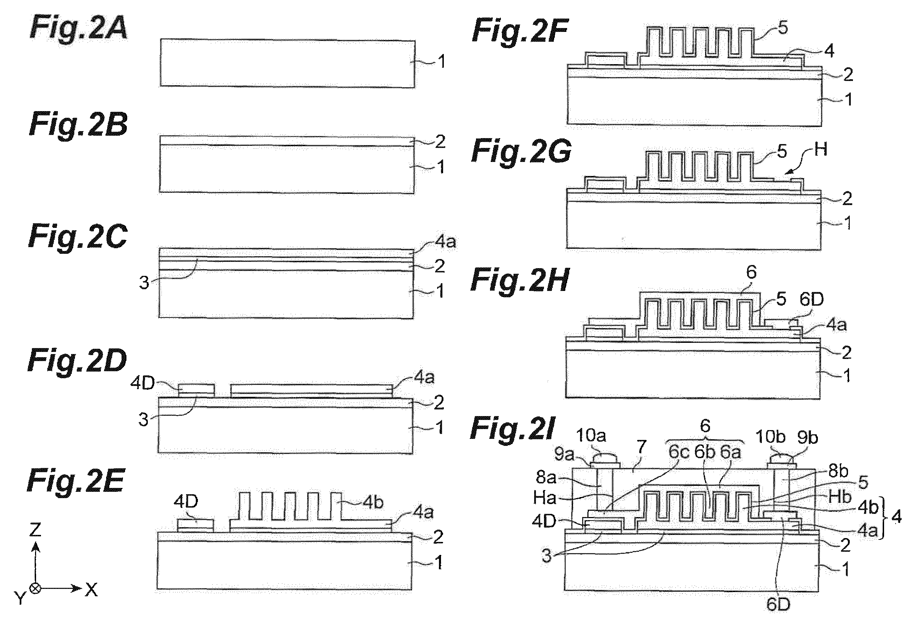

FIGS. 2A, 2B, 2C, 2D, 2E, 2F, 2G, 2H, and 2I are diagrams illustrating a process of manufacturing the thin film capacitor.

First, as in FIG. 2A, the substrate 1 is prepared. Although an insulator or a semiconductor can be used as a substrate material, Si is used as the substrate material in view of ease of working and processing in this example.

Next, as in FIG. 2B, the stress adjustment layer 2 is formed on the substrate 1. The formation method includes a sputtering method, a vapor deposition method, a chemical vapor deposition (CVD) method, etc. according to a material. In this example, because silicon nitride (SiNx) is used as the stress adjustment layer 2 (x is a proper natural number and $Si_3N_4$ or the like is mainly used), the sputtering method targeting the silicon nitride is used as the formation method.

Thereafter, as in FIG. 2C, the base layer 3 is formed on the stress adjustment layer 2 and then the initial common electrode part 4a of the lower electrode is formed on the stress adjustment layer 2. A method of forming the above-described elements includes a sputtering method, a vapor deposition method, a plating method, etc. Both the base layer 3 and the initial common electrode part 4a (lower electrode) contain copper (Cu) as a main component (an atomic percentage is 50% or more), and a material for increasing the adhesive strength such as Cr can be mixed with the base layer 3 as necessary.

Next, as in FIG. 2D, the initial common electrode part 4a and the base layer 3 are patterned according to photolithography and a part is separated from a main body part and designated as a dummy electrode 4D. That is, a mask in which a part to be removed by performing etching is opened is formed on the initial common electrode part 4a and the mask is removed after etching is performed via the mask. In addition to wet etching, a dry etching method such as an Ar milling method or a reactive ion etching (RIE) method can be used as the etching. In the wet etching of copper, hydrogen peroxide or the like can be used.

Next, as in FIG. 2E, a comb tooth part including a plurality of projecting portions 4b is formed on the common electrode part 4a. The plurality of projecting portions 4b are patterned according to photolithography. That is, a mask in which a part for growing a plated layer serving as the projecting portion 4b is opened is formed on the common electrode part 4a and the mask is removed after the projecting portion 4b is grown within the opening of the mask. Alternatively, the plated layer serving as the projecting portion 4b is formed on the common electrode part 4a, the mask is formed on the common electrode part 4a, the opening of the mask is etched to leave the projecting portion 4b, and then the mask is removed.

Next, as in FIG. 2F, a dielectric thin film 5 is formed on the lower electrode 4 and the dummy electrode 4D. Although the dielectric thin film 5 of this example is $Al_2O_3$, another dielectric such as MgO or $SiO_2$ may be used. A method of forming the dielectric thin film 5 includes a sputtering method, a CVD method, or an atomic layer deposition (ALD) method. For example, it is possible to use a sputtering method targeting alumina, but the ALD method of alternately supplying trimethyl aluminum (TMA) which is an Al raw material and $H_2O$ which is an O raw material on the substrate surface is used in this example.

Next, as in FIG. 2G, a contact hole H is formed in a part of the dielectric thin film 5 using photolithography technology. Dry etching or wet etching can be used in the formation. Ar milling can be used as the dry etching.

Thereafter, as in FIG. 2H, using the photolithography technology, a mask is formed on the dielectric thin film and the upper electrode 6 and the lower contact electrode 6D are simultaneously formed on the dielectric thin film 5 via the opening of the mask. Because a part of the dielectric thin film 5 is opened through a contact hole, a part of the lower electrode 4 is connected to the lower contact electrode 6D and the remaining part of the upper electrode 6 forms a main body part of the capacitor with the lower electrode and the dielectric thin film. In the formation, it is possible to use the sputtering method, the vapor deposition method, and the plating method. The upper electrode 6 contains copper (Cu) as a main component (an atomic percentage is 50% or more).

Next, as in FIG. 2I, the whole structure is covered with the protective film 7, the mask is formed on the protective film 7 using the photolithography technology, two openings are made in the mask, and the contact holes Ha and Hb are formed by etching the insides of the two openings. Although it is only necessary for the protective film 7 to be an insulating material, a resin material (polyimide) is adopted in this example. It is possible to use a coating method based on a spin coater or the like in the formation. Next, the first connection electrode 8a and the second connection electrode 8b are embedded within the contact holes. When the materials of the first connection electrode 8a and the second connection electrode 8b have copper (Cu) as the main component, it is possible to use a vapor deposition method, a sputtering method, a plating method, or the like in a method of forming the above-described elements.

The under bump metal 9a and the under bump metal 9b serving as conductive pads are provided on the first connection electrode 8a and the second connection electrode 8b. These can function as contact electrodes and the under bump metal can be further provided on the contact electrode using a different material. Bumps 10a and 10b are arranged on the under bump metals 9a and 9b, respectively. Cu, Ni, and Au can be used as materials of the under bump metal or the contact electrode. These can be stacked or mixed for use for each material. Preferably, it is possible to perform plating of Ni and Au on Cu.

Also, if the vertical cross section has the uneven surface structure, various types are considered as the structure of the lower electrode 4. Also, a plurality of thin film capacitors like that described above can be formed on a single wafer and can be separately used by performing dicing individually or for a desired group.

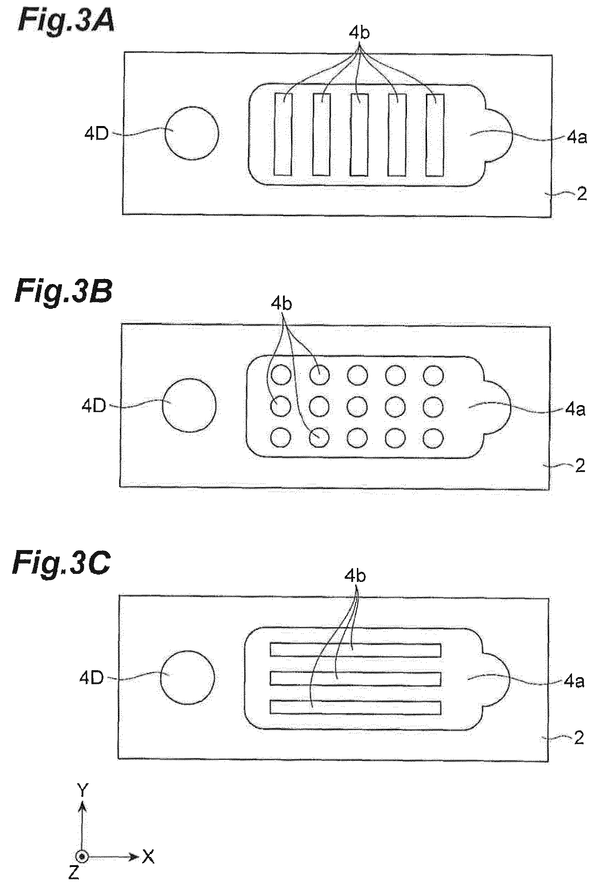

FIGS. 3A, 3B, and 3C are plan views of various lower electrodes 4 and dummy electrodes 4D. Also, output extraction electrodes (bumps 10a and 10b) of the capacitor in FIG. 1 are separated in the X-axis direction.

In the case of the structure of FIG. 3A, the lower electrode 4 has a plurality of projecting portions 4b projecting in the +Z-axis direction and extending in the Y-axis direction. A groove is formed between the projecting portions 4b. The common electrode part 4a serving as a base is generally rectangular. Also, the dummy electrode 4D is separated from the common electrode part 4a.

In the case of the structure of FIG. 3B, the lower electrode 4 has a plurality of projecting portions 4b projecting in the +Z-axis direction and two-dimensionally arranged in a dot shape within the XY plane. A space of a recess portion is formed between the projecting portions 4b. The common electrode part 4a serving as the base is generally rectangular. Also, the dummy electrode 4D is separated from the common electrode part 4a.

In the case of the structure of FIG. 3C, the lower electrode 4 has a plurality of projecting portions 4b projecting in the +Z-axis direction and extending in the X-axis direction. A groove is formed between the projecting portions 4b. The common electrode part 4a serving as the base is generally rectangular. Also, the dummy electrode 4D is separated from the common electrode part 4a.

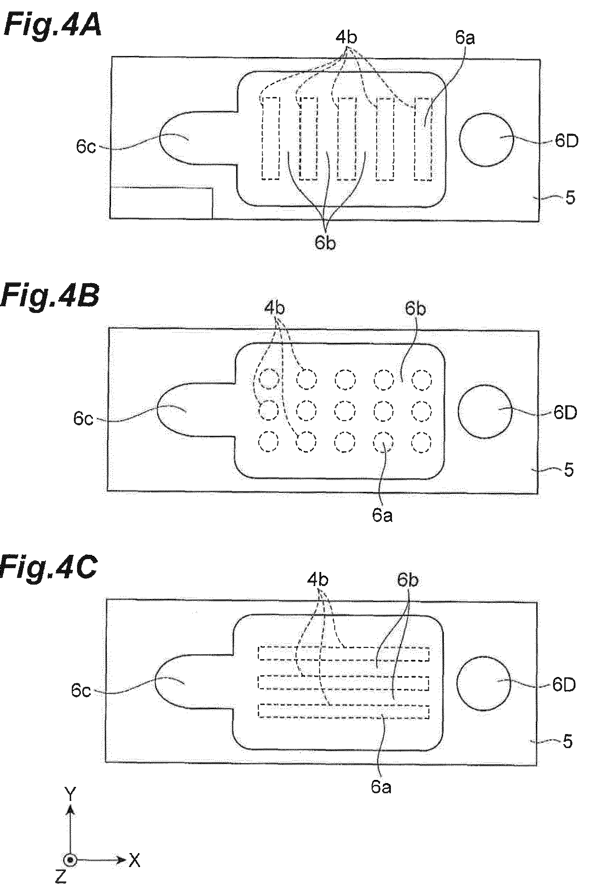

FIGS. 4A, 4B, and 4C are plan views of various upper electrodes and lower contact electrodes.

In the case of the structure of FIG. 4A, the upper electrode 6 has a plurality of projecting portions 6b projecting in the -Z-axis direction and extending in the Y-axis direction and the projecting portions 6b are positioned between the projecting portions 4b. A groove recessed in the +Z-axis direction is formed between the projecting portions 6b and the projecting portion 4b is housed in the groove. The common electrode part 6a serving as the base is generally rectangular, the contact portion 6c extends in the -X-axis direction from one end of the common electrode part 6a, and the lower contact electrode 6D is separated from the common electrode part 6a.

In the case of the structure of FIG. 4B, the upper electrode 6 has a projecting portion 6b projecting in the -Z-axis direction and configured to embed the periphery of a plurality of projecting portions 4b. A space of a recess portion recessed in the +Z-axis direction for housing the projecting portion 4b is formed between the projecting portions 6b. The common electrode part 6a serving as the base is generally rectangular, the contact portion 6c extends in the -X-axis direction from one end of the common electrode part 6a, and the lower contact electrode 6D is separated from the common electrode part 6a.

In the case of the structure of FIG. 4C, the upper electrode 6 has a plurality of projecting portions 6b projecting in the -Z-axis direction and extending in the X-axis direction, and these are positioned between the projecting portions 4b. A groove recessed in the +Z-axis direction is formed between the projecting portions 6b and houses the projecting portion 4b. The common electrode part 6a serving as the base is generally rectangular, the contact portion 6c extends in the -X-axis direction from one end of the common electrode part 6a, and the lower contact electrode 6D is separated from the common electrode part 6a.

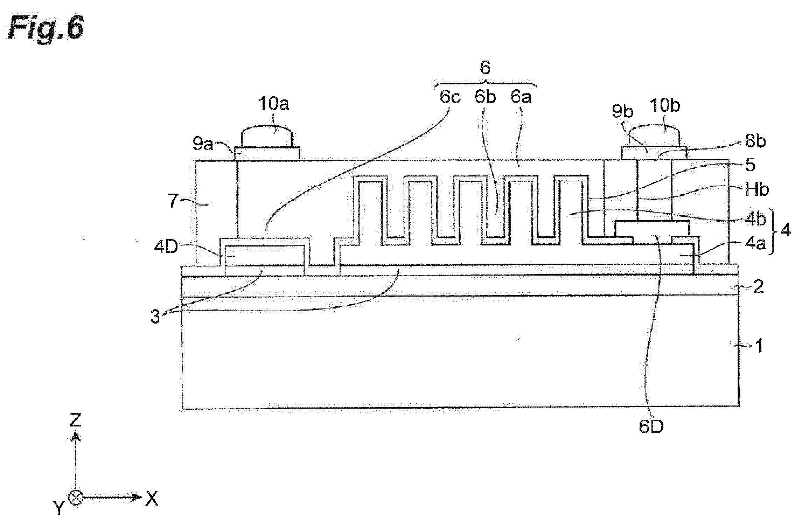

FIG. 6 is a diagram illustrating a vertical cross-sectional configuration of the thin film capacitor according to a modified embodiment.

The structure illustrated in FIG. 6 is a structure in which the thickness of the upper electrode 6 is thicker than that of the structure illustrated in FIG. 1 and the upper electrode 6 also serves as a first connection electrode and therefore the contact electrode and/or the under bump metal 9a are directly formed on the upper electrode 6 formed within the protective film 7. Other structures are the same as those illustrated in FIG. 1.

Next, the material of each element described above will be described.

The lower electrode 4 includes Cu as a main component. Also, the lower electrode 4 is assumed to be Cu of 100 (atm%). The upper electrode 6 also includes Cu as the main component. These can also be constituted of the same material or different materials. In this example, these are assumed to have the same material and the same physical properties. The substrate 1 is made of Si and the stress adjustment layer 2 is made of silicon nitride.

In this case, the Young's modulus $E_{SS}$ of the substrate 1, the Young's modulus $E_{SC}$ of the stress adjustment layer 2, and the Young's modulus $E_{LE}$ of the lower electrode 4 satisfy the following relational expressions.

Relational expressions:

$$E_{LE} < E_{SC}$$

$$E_{SS} < E_{SC}$$

According to this thin film capacitor, the deformation of the lower electrode 4 is suppressed because the stress adjustment layer 2 is harder than the softest lower electrode 4 and the substrate 1 for supporting the lower electrode 4 (has a higher Young's modulus) among the above-described three elements, and the damage associated with the deformation of the dielectric thin film 5 adjacent to the lower electrode and the characteristic deterioration associated with the damage can be suppressed.

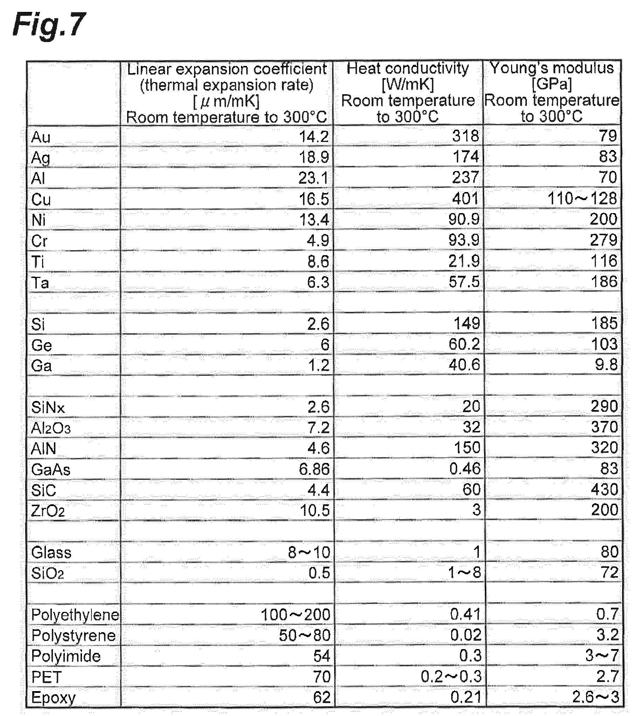

The dielectric thin film 5 is made of $Al_2O_3$, but another dielectric material (insulating material) can be used. The Young's modulus of $Al_2O_3$ is 370. Cu, Si, SiNx, and $Al_2O_3$ are arranged in ascending order of Young's modulus. When the Young's modulus of the dielectric thin film is high and its damage is suppressed, the present invention is more effective. Characteristic data of each element is as shown in the chart of FIG. 7.

Also, Cu is used as an electrode material, but a metal material illustrated in FIG. 7 may be mixed with the electrode material. That is, one or more types selected from the group of metals consisting of Au, Ag, Al, Ni, Cr, Ti, and Ta may be mixed with Cu. Manufacturing can be simplified if the materials of the lower electrode and the upper electrode are the same, but they may be different.

Also, GaAs, SiC, Ge, or Ga can be used as a material constituting the substrate in addition to Si as illustrated in FIG. 7.

As illustrated in FIG. 7, SiNx, AlN, $SiO_2$, $ZrO_2$, glass, polyethylene, polystyrene, polyimide, polyethylene terephthalate (PET), or an epoxy resin can be used as the material of the dielectric thin film. Also, these dielectrics can be used as the material of the protective film.

Also, a linear expansion coefficient $\alpha_{SS}$ of the substrate 1, a linear expansion coefficient $\alpha_{SC}$ of the stress adjustment layer 2, and a linear expansion coefficient $\alpha_{LE}$ of the lower electrode 4 satisfy the following relational expressions.

Relational expressions:

$$\alpha_{SC} < \alpha_{LE}$$

$$\alpha_{SC} < \alpha_{SS}$$

In this case, because the linear expansion coefficient of the stress adjustment layer is small even when thermal expansion occurs in the substrate or the lower electrode, the deformation of the lower electrode due to a change in a temperature decreases due to the suppression of thermal expansion of the substrate or the lower electrode and the damage of the dielectric thin film adjacent to the substrate or the lower electrode and the characteristic deterioration associated with the damage can be suppressed.

In the third thin film capacitor, it is preferable that a heat conductivity $\lambda_{SS}$ of the substrate, a heat conductivity $\lambda_{SC}$ of the stress adjustment layer, and a heat conductivity $\lambda_{LE}$ of the lower electrode satisfy the following relational expressions.

Relational expressions:

$$\lambda_{SC} < \lambda_{SS}$$

$$\lambda_{SC} < \lambda_{LE}$$

In this case, because the heat conductivity of the stress adjustment layer decreases even when the change in the temperature occurs in the substrate or the lower electrode, the deformation of the lower electrode decreases due to the suppression of the heat conduction of the substrate and the lower electrode and the suppression of the occurrence of linear expansion, and the damage of the dielectric thin film adjacent to the substrate and the lower electrode and the characteristic deterioration according to the damage can be suppressed. In particular, the effect tends to be large in terms of the fact that the change in the temperature in a substrate having a relatively large volume does not affect the lower electrode.

(Experiment examples)

The effect based on the above relational expressions was confirmed not only logically as described above but also though experiments.

A plurality of capacitors like that illustrated in FIG. 1 were formed within a single chip and the tolerance of each capacitor was measured. A Y-axis direction length (width) of the manufactured thin film capacitor is 0.1 mm and an X-axis direction length (length) is 0.4 mm. 1000 samples of each example were formed on the same Si wafer. The thickness of the wafer (substrate) is 2 mm, the thickness of the stress adjustment layer is 1 $\mu$m, a material of the dielectric thin film sandwiched between the upper electrode and the lower electrode is $Al_2O_3$ manufactured by an ALD method and has a thickness of 1400 A. Materials of the upper electrode and the lower electrode are the same, the thicknesses of the common electrode parts thereof are the same (2 $\mu$m), the pitch of the uneven surface structure is 4 $\mu$m, the height of the projecting portion in each uneven surface structure is 8 $\mu$m, the material of the protective film configured to cover the upper electrode is polyimide, and the plating of Ni and Au is performed on Cu for the connection electrode passing through the inside of the protective film, a contact electrode positioned at a termination end of the connection electrode, or the under bump metal. These electrodes were prepared using a plating method.

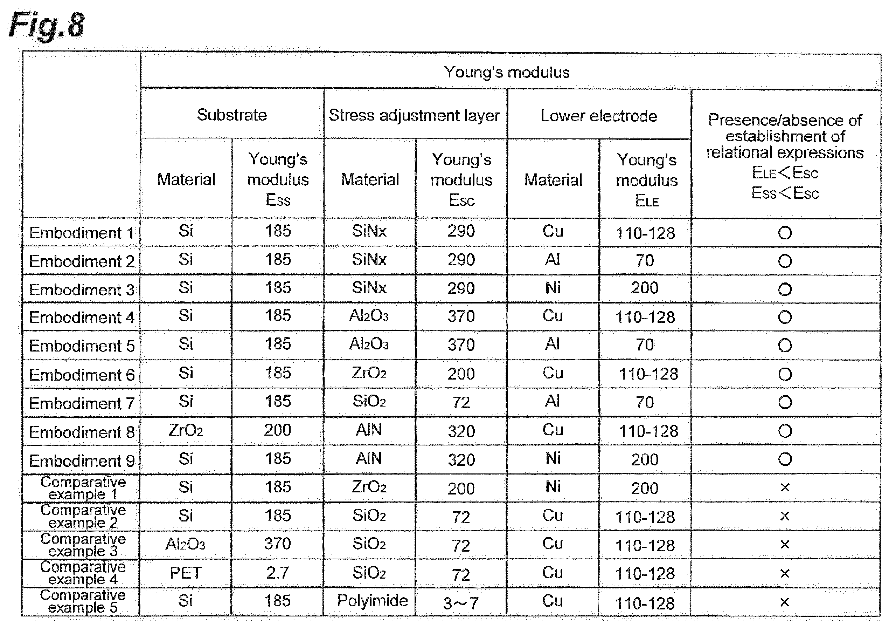

FIG. 8 is a chart illustrating experiment conditions of Young's moduli in experiment examples (embodiments and comparative examples) in the first type of invention. Hereinafter, experiment examples in the first type of invention will be described.

In Embodiment 1, Si was used as the substrate, SiNx was used as the stress adjustment layer, and Cu was used as the lower electrode. In this case, the relational expressions $E_{LE} < E_{SC}$ and $Ess < E_{SC}$ related to Young's modulus E are satisfied.

In Embodiment 2, Si was used as the substrate, SiNx was used as the stress adjustment layer, and Al was used as the lower electrode. In this case, the relational expressions $E_{LE} < E_{SC}$ and $Ess < E_{SC}$ related to Young's modulus E are satisfied.

In Embodiment 3, Si was used as the substrate, SiNx was used as the stress adjustment layer, and Ni was used as the lower electrode. In this case, the relational expressions $E_{LE} < E_{SC}$ and $Ess < E_{SC}$ related to Young's modulus E are satisfied.

In Embodiment 4, Si was used as the substrate, $Al_2O_3$ was used as the stress adjustment layer, and Cu was used as the lower electrode. In this case, the relational expressions $E_{LE} < E_{SC}$ and $Ess < E_{SC}$ related to Young's modulus E are satisfied.

In Embodiment 5, Si was used as the substrate, $Al_2O_3$ was used as the stress adjustment layer, and Al was used as the lower electrode. In this case, the relational expressions $E_{LE} < E_{SC}$ and $Ess < E_{SC}$ related to Young's modulus E are satisfied.

In Embodiment 6, Si was used as the substrate, $ZrO_2$ was used as the stress adjustment layer, and Cu was used as the lower electrode. In this case, the relational expressions $E_{LE} < E_{SC}$ and $Ess < E_{SC}$ related to Young's modulus E are satisfied.

In Embodiment 7, Si was used as the substrate, $SiO_2$ was used as the stress adjustment layer, and Al was used as the lower electrode. In this case, the relational expressions $E_{LE} < E_{SC}$ and $Ess < E_{SC}$ related to Young's modulus E are satisfied.

In Embodiment 8, $ZrO_2$ was used as the substrate, AlN was used as the stress adjustment layer, and Cu was used as the lower electrode. In this case, the relational expressions $E_{LE} < E_{SC}$ and $Ess < E_{SC}$ related to Young's modulus E are satisfied.

In Embodiment 9, Si was used as the substrate, AlN was used as the stress adjustment layer, and Ni was used as the lower electrode. In this case, the relational expressions $E_{LE} < E_{SC}$ and $Ess < E_{SC}$ related to Young's modulus E are satisfied.

In comparative example 1, Si was used as the substrate, $ZrO_2$ was used as the stress adjustment layer, and Ni was used as the lower electrode.

In comparative example 2, Si was used as the substrate, $SiO_2$ was used as the stress adjustment layer, and Cu was used as the lower electrode.

In comparative example 3, $Al_2O_3$ was used as the substrate, $SiO_2$ was used as the stress adjustment layer, and Cu was used as the lower electrode.

In comparative example 4, polyethylene terephthalate (PET) was used as the substrate, $SiO_2$ was used as the stress adjustment layer, and Cu was used as the lower electrode.

In comparative example 5, Si was used as the substrate, polyimide was used as the stress adjustment layer, and Cu was used as the lower electrode.

In comparative examples 1 to 6, unlike embodiments 1 to 6, the relational expressions $E_{LE} < E_{SC}$ and $Ess < E_{SC}$ related to Young's modulus E are not satisfied.

1000 samples were prepared for each experiment example and a voltage of 30 V was continuously applied between the upper and lower electrodes under an environment of 85% humidity and a temperature of 85°C. After the environmental test for 24 hours, a sample having an insulation resistance of $10^{11}$ $\Omega$ or more was designated as a normal product and a sample having an insulation resistance of less than $10^{11}$ $\Omega$ was designated as a defective product.

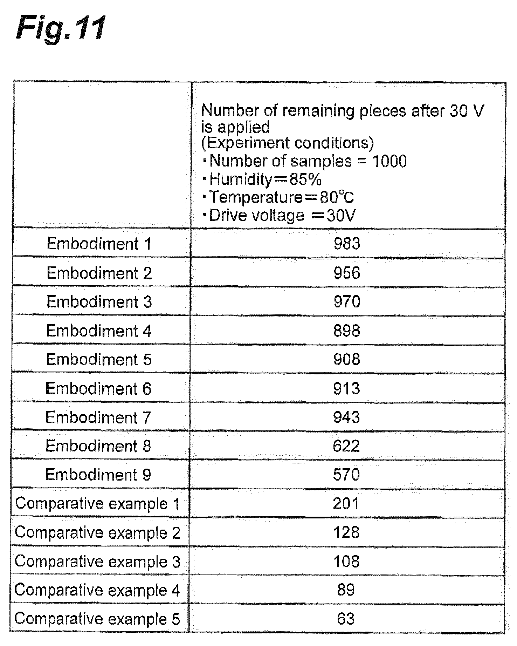

FIG. 11 is a chart illustrating the number of normal products after an environmental test was performed on samples of the above-described experiment examples (embodiments and comparative examples).

In embodiment 1, the number of normal products among the 1000 samples was 983. In embodiment 2, the number of normal products among the 1000 samples was 956. In embodiment 3, the number of normal products among the 1000 samples was 970. In embodiment 4, the number of normal products among the 1000 samples was 898. In embodiment 5, the number of normal products among the 1000 samples was 908. In embodiment 6, the number of normal products among the 1000 samples was 913. In embodiment 7, the number of normal products among the 1000 samples was 943. In embodiment 8, the number of normal products among the 1000 samples was 622. In embodiment 9, the number of normal products among the 1000 samples was 570. In comparative example 1, the number of normal products among the 1000 samples was 201. In comparative example 2, the number of normal products among the 1000 samples was 128. In comparative example 3, the number of normal products among the 1000 samples was 108. In comparative example 4, the number of normal products among the 1000 samples was 89. In comparative example 5, the number of normal products among the 1000 samples was 63.

As described above, when the relational expressions $E_{LE} < E_{SC}$ and $E_{SS} < E_{SC}$ related to Young's modulus E are satisfied as shown in data of embodiments 1 to 9, it can be seen that the environmental tolerance increases more than those of comparative examples 1 to 5 which do not satisfy these relational expressions.

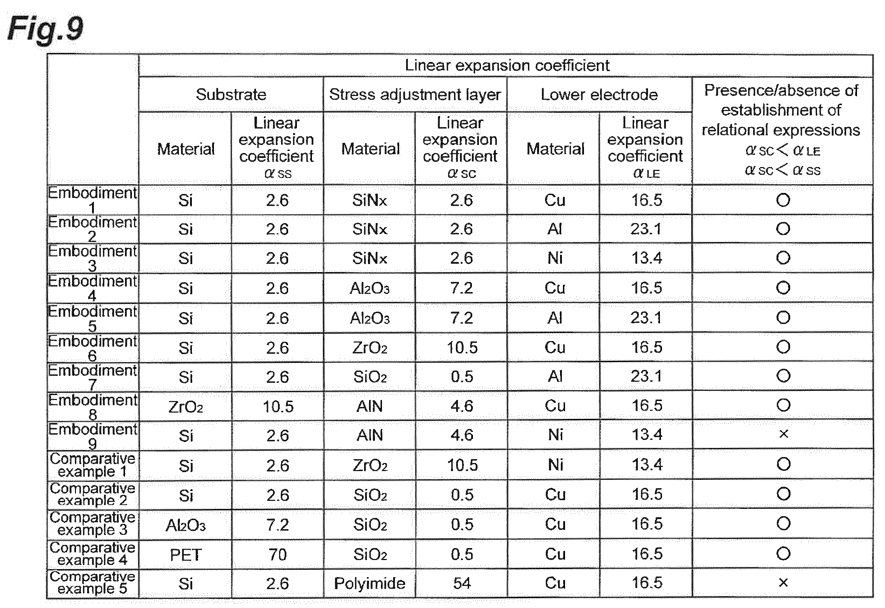

FIG. 9 is a chart illustrating relations of linear expansion coefficients in experiment examples (embodiments and comparative examples).

The relational expressions $\alpha_{SC} < \alpha_{LE}$ and $\alpha_{SC} < \alpha_{SS}$ related to the linear expansion coefficient $\alpha$ are satisfied in embodiments 1 to 8 and are not satisfied in embodiment 9. Also, the relational expressions $\alpha_{SC} < \alpha_{LE}$ and $\alpha_{SC} < \alpha_{SS}$ related to the linear expansion coefficient $\alpha$ are satisfied in comparative examples 1 to 4 and are not satisfied in comparative example 5.

As illustrated in FIG 11, the environmental tolerance of the case in which the linear expansion coefficients satisfy the above-described relational expressions $\alpha_{SC} < \alpha_{LE}$ and $\alpha_{SC} < \alpha_{SS}$ when the relational expressions of the above-described Young's modulus are satisfied as in embodiments 1 to 8 is clearly greater than that of the case in which the linear expansion coefficients do not satisfy the above-described relational expressions as in embodiment 9. That is, the number of normal products (570) of embodiment 9 < the number of normal products (622 to 983) of embodiments 1 to 8, and it can be seen that the environmental tolerance is further improved when the relational expressions of the linear expansion coefficients are satisfied.

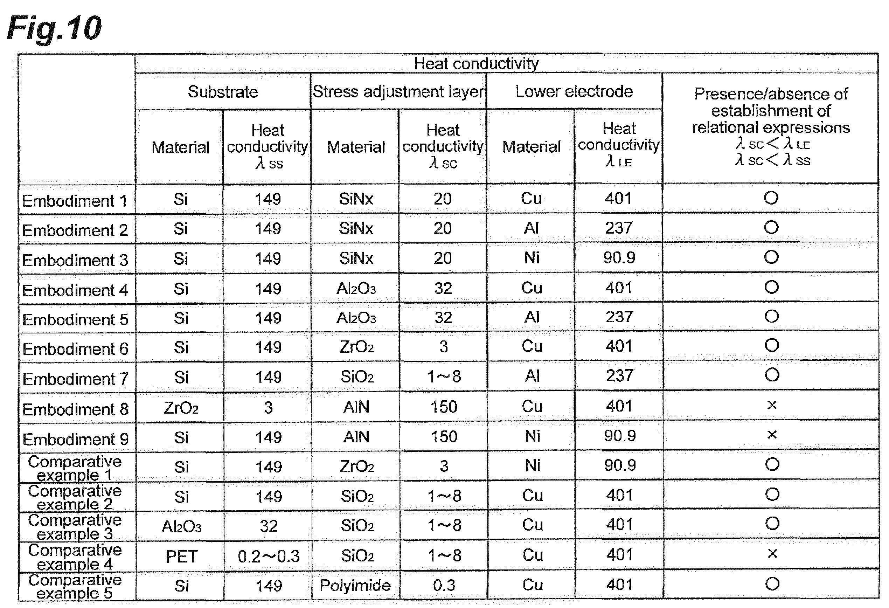

FIG. 10 is a chart illustrating relations of heat conductivity in experiment examples (embodiments and comparative examples).

The relational expressions $\lambda_{SC} < \lambda_{SS}$ and $\lambda_{SC} < \lambda_{LE}$ related to the heat conductivities $\lambda$ are satisfied in embodiments 1 to 7 and are not satisfied in embodiments 8 and 9. Also, the relational expressions $\lambda_{SC} < \lambda_{SS}$ and $\lambda_{SC} < \lambda_{LE}$ related to the heat conductivities $\lambda$ are satisfied in comparative examples 1 to 3 and comparative example 5 and are not satisfied in comparative example 4.

As illustrated in FIG 11, the environmental tolerance of the case in which the heat conductivities satisfy the above-described relational expressions $\lambda_{SC} < \lambda_{SS}$ and $\lambda_{SC} < \lambda_{LE}$ when the relational expressions of the above-described Young's moduli are satisfied as in embodiments 1 to 7 is clearly greater than that of the case in which the heat conductivities do not satisfy the above-described relational expressions as in embodiments 8 and 9. That is, the number of normal products (622 and 570) of embodiments 8 and 9 < the number of normal products (898 to 983) of embodiments 1 to 7, and it can be seen that the environmental tolerance is further improved when the relational expressions of the linear expansion coefficients are satisfied.

As described above, it is possible to increase capacitance because the thin film capacitor having an uneven surface structure is a structure in which an area opposite to the electrode in a unit volume increases. On the other hand, because the electrode is subdivided, the strength is degraded, a mechanical force generated by a temperature increase during mounting or an environment during actual use is transferred to a dielectric layer and the dielectric layer may be destroyed. In this embodiment, this destruction is suppressed. A lower electrode in which the shape of the vertical cross section is a comb tooth or slit shape or a lower electrode in which the shape of the vertical cross section is a shape including a pin or hole can be used as the uneven surface structure of the lower electrode, and the structures of the lower electrode and the upper electrode can also be replaced with each other.

As described above, it is possible to suppress stress accumulation for the dielectric thin film and suppress the characteristic deterioration by satisfying the above-described predetermined conditions.

Next, an overview of a second type of invention will be described.

In the second type of invention, a thin film capacitor of a first aspect is a thin film capacitor including: a substrate; an insulating layer formed on a main surface of the substrate; a lower electrode formed on the insulating layer; a dielectric thin film configured to cover the lower electrode; and an upper electrode formed on the dielectric thin film, wherein the lower electrode has an uneven surface structure of a vertical cross section in a thickness direction of the substrate, wherein the upper electrode has an uneven surface structure of a vertical cross section in a thickness direction of the substrate, wherein a projecting portion of the upper electrode projecting to a lower electrode side is positioned in a gap between projecting portions of the lower electrode, wherein, when an XYZ three-dimensional coordinate system is set, the main surface is an XY plane, and a direction in which a plurality of projecting portions of the lower electrode are arranged is designated as an X-axis direction, a distal end of the projecting portion of the lower electrode within the XZ plane has a corner portion with a radius R1 of curvature in which a center of curvature is positioned inside the projecting portion, and wherein the radius R1 of curvature and a thickness td of the dielectric thin film satisfy the relational expression $0.4 \times td \le R1 \le 20 \times td$.

When the radius R1 of curvature is less than 0.4 times the thickness td of the dielectric thin film according to the thin film capacitor, the antenna effect increases, an electric field is concentrated on the dielectric thin film, and an internal defect of the dielectric thin film occurs while an element is used. When the radius R1 of curvature is greater than 20 times the thickness td of the dielectric thin film, the antenna effect is degraded, but the corner portion of the above-described projecting portion is formed to be more gentle than necessary, the stress applied in the in-plane direction of the dielectric thin film in the in-plane direction of the corner portion increases, and cracks tend to be introduced into a crystalline grain boundary of the dielectric thin film. Also, because a crystalline grain boundary density of the electrode in the above-described corner portion becomes rough to the extent that the electric field tends to concentrate, the concentration of an electric field due to a crystalline grain boundary of the lower electrode tends to occur.

In the thin film capacitor of a second aspect, a proximal end of the projecting portion of the lower electrode within the XZ plane has a corner portion with a radius R2 of curvature in which a center of curvature is positioned outside the projecting portion, and the radius R2 of curvature and the thickness td of the dielectric thin film satisfy the relational expression $0.4 \times td \leq R2 \leq 20 \times td$.

The recess portion between proximal ends of the lower electrode is opposite to a distal end of the downward projecting portion of the upper electrode. Therefore, the influence of the electric field on the dielectric thin film interposed between the lower electrode and the upper electrode similarly occurs in the distal end of the projecting portion in the lower electrode and the proximal end.

That is, when the radius R2 of curvature is less than 0.4 times the thickness td of the dielectric thin film even in the proximal end, the antenna effect increases, an electric field is concentrated on the dielectric thin film, and an internal defect of the dielectric thin film occurs while an element is used. When the radius R2 of curvature is greater than 20 times the thickness td of the dielectric thin film, the antenna effect is degraded, but malfunctions such as the stress applied in the in-plane direction of the dielectric thin film in the in-plane direction of the corner portion increasing and cracks are introduced into the dielectric thin film or the concentration of an electric field due to a crystalline grain boundary of the electrode tending to occur in the corner portion occur.

The condition for satisfying the above-described radius of curvature is not satisfied only within the XZ plane, so that the concentration of the electric field also similarly occurs in the periphery of the corner portion within the YZ plane from a point of view of the concentration of the electric field based on a shape for the corner portion.

Therefore, in the thin film capacitor of a third aspect, the distal end of the projecting portion of the lower electrode within the YZ plane has a corner portion with a radius R3 of curvature in which a center of curvature is positioned inside the projecting portion, and the radius R3 of curvature and the thickness td of the dielectric thin film satisfy the relational expression $0.4 \times td \leq R3 \leq 20 \times td$.

Thereby, when the radius R3 of curvature is less than 0.4 times the thickness td of the dielectric thin film even in the YZ plane as described above, the antenna effect increases, an electric field is concentrated on the dielectric thin film, and an internal defect of the dielectric thin film occurs while an element is used. When the radius R3 of curvature is greater than 20 times the thickness td of the dielectric thin film, the antenna effect is degraded, but malfunctions such as the stress applied in the in-plane direction of the dielectric thin film in the in-plane direction of the corner portion increasing and cracks tending to be introduced into the dielectric thin film or the concentration of an electric field due to a crystalline grain boundary of the electrode tending to occur in the corner portion occur.

Likewise, a similar structure to the case of the XZ plane is provided in the proximal end of the projecting portion within the YZ plane and therefore the similar actions and effects occur.

That is, in the thin film capacitor of a fourth aspect, the distal end of the projecting portion of the lower electrode within the YZ plane has a corner portion with a radius R4 of curvature in which a center of curvature is positioned outside the projecting portion, and the radius R4 of curvature and the thickness td of the dielectric thin film satisfy the relational expression $0.4 \times td \leq R4 \leq 20 \times td$.

Thereby, when the radius R4 of curvature is less than 0.4 times the thickness td of the dielectric thin film even in the YZ plane as described above, the antenna effect increases, an electric field is concentrated on the dielectric thin film, and an internal defect of the dielectric thin film occurs while an element is used. When the radius R4 of curvature is greater than 20 times the thickness td of the dielectric thin film, the antenna effect is degraded, but malfunctions such as the stress applied in the in-plane direction of the dielectric thin film in the in-plane direction of the corner portion increasing and cracks tending to be introduced into the dielectric thin film or the concentration of an electric field due to a crystalline grain boundary of the electrode tending to occur in the corner portion occur

Also, in the thin film capacitor of a fifth aspect, it is further preferable that the relational expression $0.5 \times td \leq R1 \leq 10 \times td$ be satisfied in relation to a value of the above-described R1. In this case, the internal defect of the dielectric thin film is suppressed more than in the case of the above-described range of R1 and malfunctions such as cracks tending to be introduced into the dielectric thin film due to stress in the in-plane direction of the dielectric thin film in the corner portion or the concentration of an electric field due to a crystalline grain boundary of the electrode tending to occur in the corner portion are also reduced.

Also, in the thin film capacitor of a sixth aspect, it is further preferable that the relational expression $0.5 \times td \leq R2 \leq 10 \times td$ be satisfied in relation to a value of the above-described R1. In this case, the internal defect of the dielectric thin film is suppressed more than in the case of the above-described range of R1 and malfunctions such as cracks tending to be introduced into the dielectric thin film due to stress in the in-plane direction of the dielectric thin film in the corner portion or the concentration of an electric field due to a crystalline grain boundary of the electrode tending to occur in the corner portion are also reduced.

In the thin film capacitor of a seventh aspect, the insulating layer is a stress adjustment layer, and the Young's modulus of the stress adjustment layer is greater than the Young's modulus of the substrate and greater than the Young's modulus of the lower electrode. When the Young's modulus of the stress adjustment layer is relatively higher than the others, mechanical distortion of the lower electrode is suppressed and therefore mechanical destruction of the dielectric thin film is suppressed. When the mechanical stress is applied to the dielectric thin film even in a state in which the internal defect slightly occurs, the dielectric thin film deteriorates and a probability of a defective product increases. However, when the Young's modulus of the stress adjustment layer increases, the stress transfer for the dielectric thin film via the lower electrode is suppressed and the characteristic deterioration of the thin film capacitor can be suppressed.

Also, any conditions of the thin film capacitor described above can be combined. According to the thin film capacitor of the present invention, it is possible to suppress the characteristic deterioration.

Hereinafter, the thin film capacitor according to the embodiment of the second type of invention will be described. Also, the same reference signs are assigned to the same elements and redundant description thereof will be omitted. Also, an XYZ three-dimensional orthogonal coordinate system is set and the thickness direction of the substrate is assumed to be the Z-axis direction.

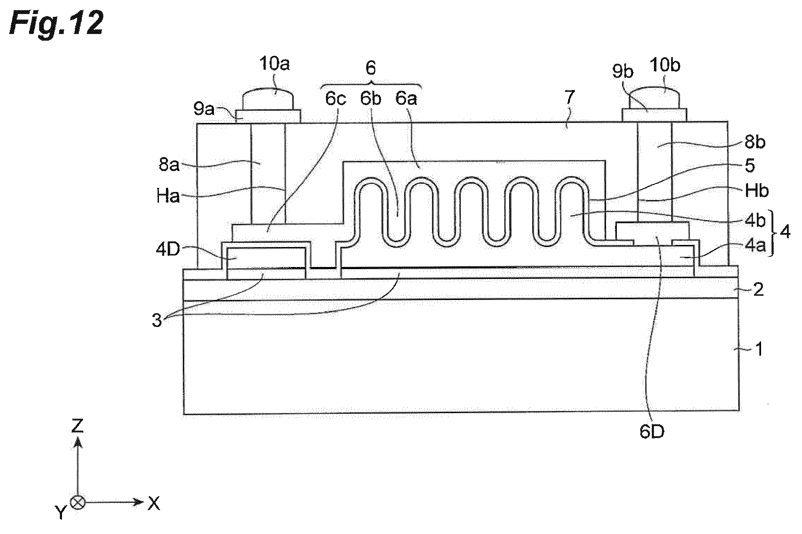

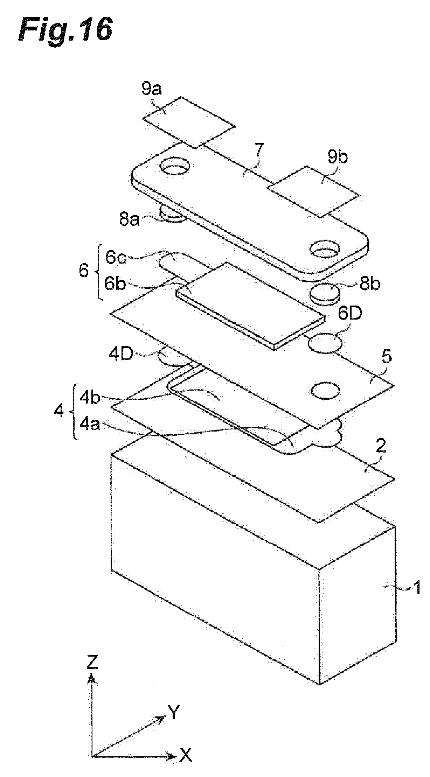

FIG. 12 is a diagram illustrating a vertical cross-sectional configuration of a thin film capacitor according to an embodiment. Also, FIG. 16 is an exploded perspective view of a thin film capacitor, but some parts such as a base layer and a protective film in FIG. 12 are omitted to clearly describe the structure. In the following description, FIGS. 12 and 16 will be appropriately referred to.

This thin film capacitor includes a substrate 1, an insulating layer 2 (stress adjustment layer 2) formed on a main surface (XY plane) of the substrate 1, a lower electrode 4 formed on the stress adjustment layer 2 via a base layer 3, a dielectric thin film 5 configured to cover the lower electrode 4, and an upper electrode 6 formed on the dielectric thin film 5.

A main part of the thin film capacitor is constituted of the lower electrode 4, the upper electrode 6, and the dielectric thin film 5 positioned between the lower electrode 4 and the upper electrode 6.

The lower electrode 4 includes the common electrode part 4a extending in parallel to the main surface of the substrate 1 and a plurality of projecting portions 4b extending to project from the common electrode part 4a away from the substrate 1. Likewise, the upper electrode 6 includes a common electrode part 6a extending in parallel to the main surface of the substrate 1 and a plurality of projecting portions 6b extending to project from the common electrode part 6a toward the substrate 1. Also, the upper electrode 6 has a contact portion 6c for enabling the connection electrode to come in contact with an external terminal.

The lower electrode 4 has an uneven surface structure of a vertical cross section (XZ plane) in the thickness direction of the substrate 1 and has a comb tooth shape. Likewise, the upper electrode 6 has an uneven surface structure of a vertical cross section (XZ plane) in the thickness direction of the substrate 1 and has a comb tooth shape. The projecting portion 6b projecting to the lower electrode side of the upper electrode 6 is positioned in a gap between the projecting portions 4b of the lower electrode 4 and a structure in which comb teeth face each other and engaged with each other is a trench structure in the vertical cross section and increases capacitance per unit area.

This thin film capacitor includes a protective film 7 configured to cover the upper electrode 6, a dummy electrode 4D formed on the stress adjustment layer 2, and a lower contact electrode 6D formed on the common electrode part 4a of the lower electrode 4 and in contact with the common electrode part 4a. The dummy electrode 4D is formed simultaneously with the common electrode part 4a of the lower electrode and the lower contact electrode 6D is formed simultaneously with the upper electrode 6.

On the left in FIG. 12 or 16 of the thin film capacitor, the dielectric thin film 5, the contact portion 6c of the upper electrode 6, and a first connection electrode 8a are positioned on the dummy electrode 4D. On the other hand, on the right in FIG. 12 or 16 of the thin film capacitor, the lower contact electrode 6D in contact with the common electrode part 4a and a second connection electrode 8b are positioned on the common electrode part 4a of the lower electrode 4 via an opening provided in the dielectric thin film 5. The dummy electrode 4D has the same thickness as the common electrode part 4a of the lower electrode 4.

Also, the first connection electrode 8a is positioned within a first contact hole Ha provided in the protective film 7 and the second connection electrode 8b is positioned within a second contact hole Hb provided in the protective film 7.

In the case of this structure, because the dummy electrode 4D has the same thickness as the common electrode part 4a of the lower electrode 4, heights of the first connection electrode 8a and the second connection electrode 8b in the thickness direction can be approximately the same and a thin film capacitor of a flat structure can be formed.

A contact electrode and/or an under bump metal 9a are in contact with the first connection electrode 8a and are positioned on the first connection electrode 8a. A contact electrode and/or an under bump metal 9b are in contact with the second connection electrode 8b and are positioned on the second connection electrode 8b. Bumps 10a and 10b are arranged on the under bump metals 9a and 9b, respectively.

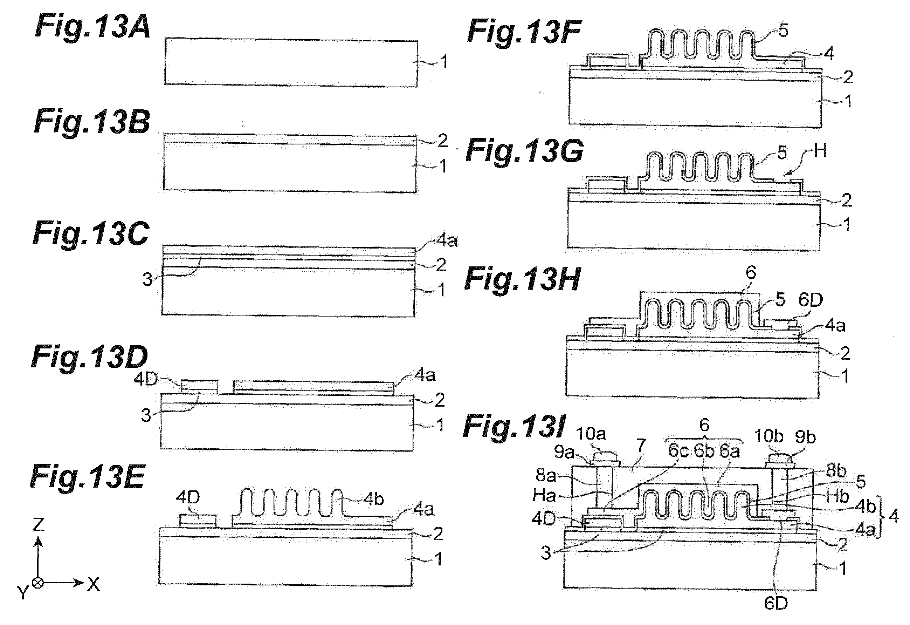

FIGS. 13A, 13B, 13C, 13D, 13E, 13F, 13G, 13H, and 13I are diagrams illustrating a process of manufacturing a thin film capacitor.

First, as in FIG. 13A, the substrate 1 is prepared. Although an insulator or a semiconductor can be used as a substrate material, Si is used as the substrate material in view of ease of working and processing in this example.

Next, as in FIG. 13B, the stress adjustment layer 2 is formed on the substrate 1. The formation method includes a sputtering method, a vapor deposition method, a chemical vapor deposition (CVD) method, etc. according to a material. In this example, because silicon nitride (SiNx) is used as the stress adjustment layer 2 (x is a proper natural number and $Si_3N_4$ or the like is mainly used), the sputtering method targeting the silicon nitride is used as the formation method.

Thereafter, as in FIG. 13C, the base layer 3 is formed on the stress adjustment layer 2 and then the initial common electrode part 4a of the lower electrode is formed on the stress adjustment layer 2. A method of forming the above-described elements includes a sputtering method, a vapor deposition method, a plating method, etc. Both the base layer 3 and the initial common electrode part 4a (lower electrode) contain copper (Cu) as a main component (an atomic percentage is 50% or more), and a material for increasing the adhesive strength such as Cr can be mixed with the base layer 3 as necessary.

Next, as in FIG. 13D, the initial common electrode part 4a and the base layer 3 are patterned according to photolithography and a part is separated from a main body part and designated as a dummy electrode 4D. That is, a mask in which a part to be removed by performing etching is opened is formed on the initial common electrode part 4a and the mask is removed after etching is performed via the mask. In addition to wet etching, a dry etching method such as an Ar milling method or a reactive ion etching (RIE) method can be used as the etching. In the wet etching of copper, hydrogen peroxide or the like can be used.

Next, as in FIG. 13E, a comb tooth part including a plurality of projecting portions 4b is formed on the common electrode part 4a. The plurality of projecting portions 4b are patterned according to photolithography. That is, a mask in which a part for growing a plated layer serving as the projecting portion 4b is opened is formed on the common electrode part 4a and the mask is removed after the projecting portion 4b is grown within the opening of the mask. Alternatively, the plated layer serving as the projecting portion 4b is formed on the common electrode part 4a, the mask is formed on the common electrode part 4a, the opening of the mask is etched to leave the projecting portion 4b, and then the mask is removed. As will be described below, a process of rounding the corner portion of the projecting portion 4b is performed.

Next, as in FIG. 13F, a dielectric thin film 5 is formed on the lower electrode 4 and the dummy electrode 4D. Although the dielectric thin film 5 of this example is $Al_2O_3$, another dielectric such as MgO or $SiO_2$ may be used. A method of forming the dielectric thin film 5 includes a sputtering method, a CVD method, or an atomic layer deposition (ALD) method. For example, it is possible to use a sputtering method targeting alumina, but the ALD method of alternately supplying trimethyl aluminum (TMA) which is an Al raw material and $H_2O$ which is an O raw material on the substrate surface is used in this example.

Next, as in FIG. 13G, a contact hole H is formed in a part of the dielectric thin film 5 using photolithography technology. Dry etching or wet etching can be used in the formation. Ar milling can be used as the dry etching.

Thereafter, as in FIG. 13H, using the photolithography technology, a mask is formed on the dielectric thin film and the upper electrode 6 and the lower contact electrode 6D are simultaneously formed on the dielectric thin film 5 via the opening of the mask. Because a part of the dielectric thin film 5 is opened through a contact hole, a part of the lower electrode 4 is connected to the lower contact electrode 6D and the remaining part of the upper electrode 6 forms a main body part of the capacitor with the lower electrode and the dielectric thin film. In the formation, it is possible to use the sputtering method, the vapor deposition method, and the plating method. The upper electrode 6 contains copper (Cu) as a main component (an atomic percentage is 50% or more).

Next, as in FIG. 13I, the whole structure is covered with the protective film 7, the mask is formed on the protective film 7 using the photolithography technology, two openings are made in the mask, and the contact holes Ha and Hb are formed by etching the insides of the two openings. Although it is only necessary for the protective film 7 to be an insulating material, a resin material (polyimide) is adopted in this example. It is possible to use a coating method based on a spin coater or the like in the formation. Next, the first connection electrode 8a and the second connection electrode 8b are embedded within the contact holes. When the materials of the first connection electrode 8a and the second connection electrode 8b have copper (Cu) as the main component, it is possible to use a vapor deposition method, a sputtering method, a plating method, or the like in a method of forming the above-described elements.

The under bump metal 9a and the under bump metal 9b serving as conductive pads are provided on the first connection electrode 8a and the second connection electrode 8b. These can function as contact electrodes and the under bump metal can be further provided on the contact electrode using a different material. Bumps 10a and 10b are arranged on the under bump metals 9a and 9b, respectively. Cu, Ni, and Au can be used as materials of the under bump metal or the contact electrode. These can be stacked or mixed for use for each material. Preferably, it is possible to perform plating of Ni and Au on Cu.

Also, if the vertical cross section has the uneven surface structure, various types are considered as the structure of the lower electrode 4. Also, a plurality of thin film capacitors like that described above can be formed on a single wafer and can be separately used by performing dicing individually or for a desired group.

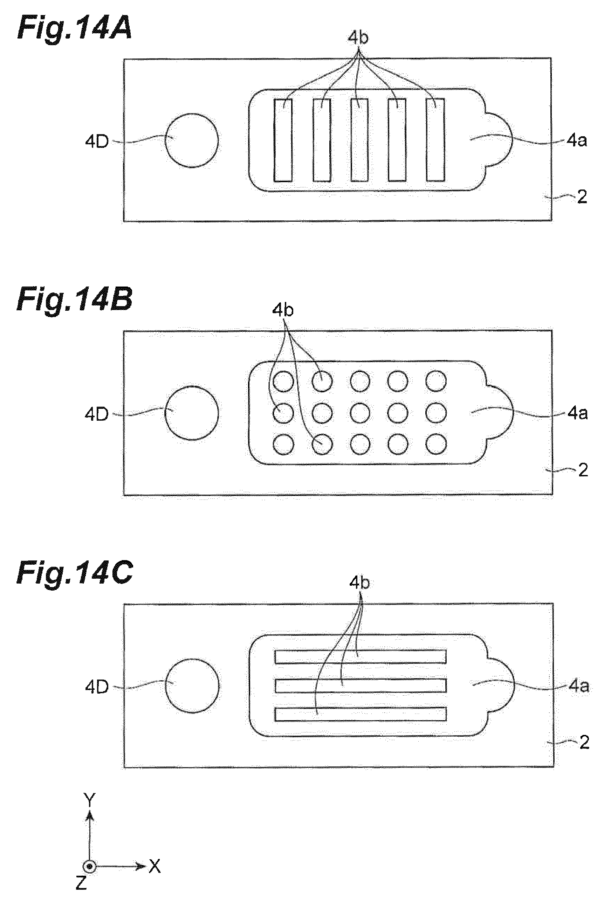

FIGS. 14A, 14B, and 14C are plan views of various lower electrodes 4 and dummy electrodes 4D. Also, output extraction electrodes (bumps 10a and 10b) of the capacitor in FIG. 1 are separated in the X-axis direction.

In the case of the structure of FIG. 14A, the lower electrode 4 has a plurality of projecting portions 4b projecting in the +Z-axis direction and extending in the Y-axis direction. A groove is formed between the projecting portions 4b. The common electrode part 4a serving as a base is generally rectangular. Also, the dummy electrode 4D is separated from the common electrode part 4a.

In the case of the structure of FIG. 14B, the lower electrode 4 has a plurality of projecting portions 4b projecting in the +Z-axis direction and two-dimensionally arranged in a dot shape within the XY plane. A space of a recess portion is formed between the projecting portions 4b. The common electrode part 4a serving as the base is generally rectangular. Also, the dummy electrode 4D is separated from the common electrode part 4a.

In the case of the structure of FIG. 14C, the lower electrode 4 has a plurality of projecting portions 4b projecting in the +Z-axis direction and extending in the X-axis direction. A groove is formed between the projecting portions 4b. The common electrode part 4a serving as the base is generally rectangular. Also, the dummy electrode 4D is separated from the common electrode part 4a.

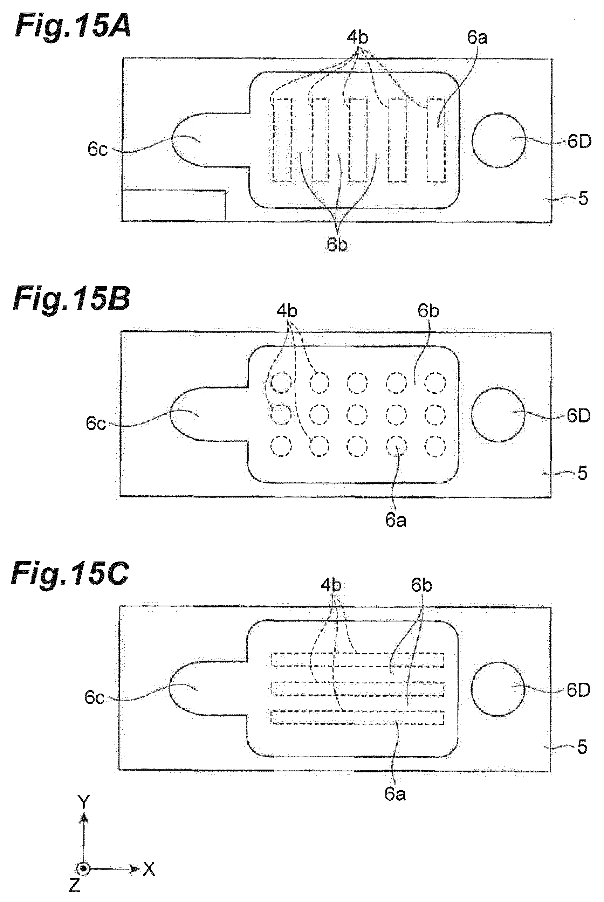

FIGS. 15A, 15B, and 15C are plan views of various upper electrodes and lower contact electrodes.

In the case of the structure of FIG. 15A, the upper electrode 6 has a plurality of projecting portions 6b projecting in the -Z-axis direction and extending in the Y-axis direction and the projecting portions 6b are formed between the projecting portions 4b. A groove recessed in the +Z-axis direction is formed between the projecting portions 6b and the projecting portion 4b is housed in the groove. The common electrode part 6a serving as the base is generally rectangular, the contact portion 6c extends in the -X-axis direction from one end of the common electrode part 6a, and the lower contact electrode 6D is separated from the common electrode part 6a.

In the case of the structure of FIG. 15B, the upper electrode 6 has a projecting portion 6b projecting in the -Z-axis direction and configured to embed the periphery of a plurality of projecting portions 4b. A space of a recess portion recessed in the +Z-axis direction for housing the projecting portion 4b is formed between the projecting portions 6b. The common electrode part 6a serving as the base is generally rectangular, the contact portion 6c extends in the -X-axis direction from one end of the common electrode part 6a, and the lower contact electrode 6D is separated from the common electrode part 6a.

In the case of the structure of FIG. 15C, the upper electrode 6 has a plurality of projecting portions 6b projecting in the -Z-axis direction and extending in the X-axis direction, and these are positioned between the projecting portions 4b. A groove recessed in the +Z-axis direction is formed between the projecting portions 6b and houses the projecting portion 4b. The common electrode part 6a serving as the base is generally rectangular, the contact portion 6c extends in the -X-axis direction from one end of the common electrode part 6a, and the lower contact electrode 6D is separated from the common electrode part 6a.

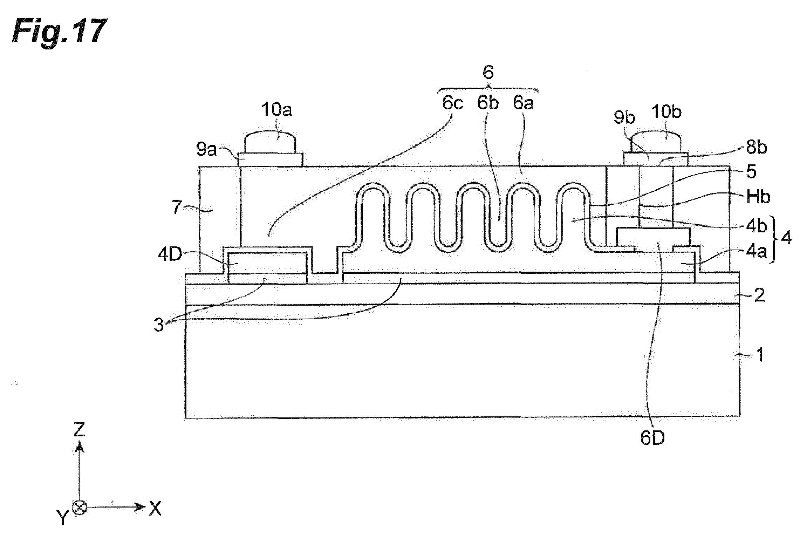

FIG. 17 is a diagram illustrating a vertical cross-sectional configuration of the thin film capacitor according to a modified embodiment.

The structure illustrated in FIG. 17 is a structure in which the thickness of the upper electrode 6 is thicker than that of the structure illustrated in FIG. 1 and the upper electrode 6 also serves as a first connection electrode and therefore the contact electrode and/or the under bump metal 9a are directly formed on the upper electrode 6 formed within the protective film 7. Other structures are the same as those illustrated in FIG. 1.

Next, the material of each element described above will be described.

The lower electrode 4 includes Cu as a main component. Also, the lower electrode 4 is assumed to be Cu of 100 (atm%). The upper electrode 6 also includes Cu as the main component. These can also be constituted of the same material or different materials. In this example, these are assumed to have the same material and the same physical properties. The substrate 1 is made of Si and the stress adjustment layer 2 is made of silicon nitride.

In this case, the Young's modulus $E_{SS}$ of the substrate 1, the Young's modulus $E_{SC}$ of the stress adjustment layer 2, and the Young's modulus $E_{LE}$ of the lower electrode 4 satisfy the following relational expressions.

Relational expressions:

$$E_{LE} < E_{SC}$$

$$E_{SS} < E_{SC}$$

According to this thin film capacitor, the deformation of the lower electrode 4 is suppressed because the stress adjustment layer 2 is harder than the softest lower electrode 4 and the substrate 1 for supporting the lower electrode 4 (has a higher Young's modulus) among the above-described three elements, and the damage associated with the deformation of the dielectric thin film 5 adjacent to the lower electrode and the characteristic deterioration associated with the damage can be suppressed.

The dielectric thin film 5 is made of $Al_2O_3$, but

another dielectric material (insulating material) can be used. The Young's modulus of $Al_2O_3$ is 370. Cu, Si, SiNx, and $Al_2O_3$ are arranged in ascending order of Young's modulus. When Young's modulus of the dielectric thin film is high and its damage is suppressed, the present invention is more effective. Characteristic data of each element is as shown in the chart of FIG. 7.

Also, Cu is used as an electrode material, but a metal material illustrated in FIG. 7 may be mixed with the electrode material. That is, one or more types selected from the group of metals consisting of Au, Ag, Al, Ni, Cr, Ti, and Ta may be mixed with Cu. Manufacturing can be simplified if the materials of the lower electrode and the upper electrode are the same, but they may be different.

Also, GaAs, SiC, Ge, or Ga can be used as a material constituting the substrate in addition to Si as illustrated in FIG. 7.

As illustrated in FIG. 7, SiNx, AlN, $SiO_2$, $ZrO_2$, glass, polyethylene, polystyrene, polyimide, polyethylene terephthalate (PET), or an epoxy resin can be used as the material of the dielectric thin film. Also, these dielectrics can be used as the material of the protective film.

Also, it is preferable that a linear expansion coefficient $\alpha_{SS}$ of the substrate 1, a linear expansion coefficient $\alpha_{SC}$ of the stress adjustment layer 2, and a linear expansion coefficient $\alpha_{LE}$ of the lower electrode 4 satisfy the following relational expressions.

Relational expressions:

$$\alpha_{SC} < \alpha_{LE}$$

$$\alpha_{SC} < \alpha_{SS}$$

In this case, because the linear expansion coefficient of the stress adjustment layer is small even when thermal expansion occurs in the substrate or the lower electrode, the deformation of the lower electrode due to a change in a temperature decreases due to the suppression of thermal expansion of the substrate or the lower electrode and the damage of the dielectric thin film adjacent to the substrate or the lower electrode and the characteristic deterioration associated with the damage can be suppressed.

In the third thin film capacitor as well, it is preferable that a heat conductivity $\lambda_{SS}$ of the substrate, a heat conductivity $\lambda_{SC}$ of the stress adjustment layer, and a heat conductivity $\lambda_{LE}$ of the lower electrode satisfy the following relational expressions.

Relational expressions:

$$\lambda_{SC} < \lambda_{SS}$$

$$\lambda_{SC} < \lambda_{LE}$$

In this case, because the heat conductivity of the stress adjustment layer decreases even when the change in the temperature occurs in the substrate or the lower electrode, the deformation of the lower electrode decreases due to the suppression of the heat conduction of the substrate and the lower electrode and the suppression of the occurrence of linear expansion, and the damage of the dielectric thin film adjacent to the substrate and the lower electrode and the characteristic deterioration according to the damage can be suppressed. In particular, the effect tends to be large in terms of the fact that the change in the temperature in a substrate having a relatively large volume does not affect the lower electrode.

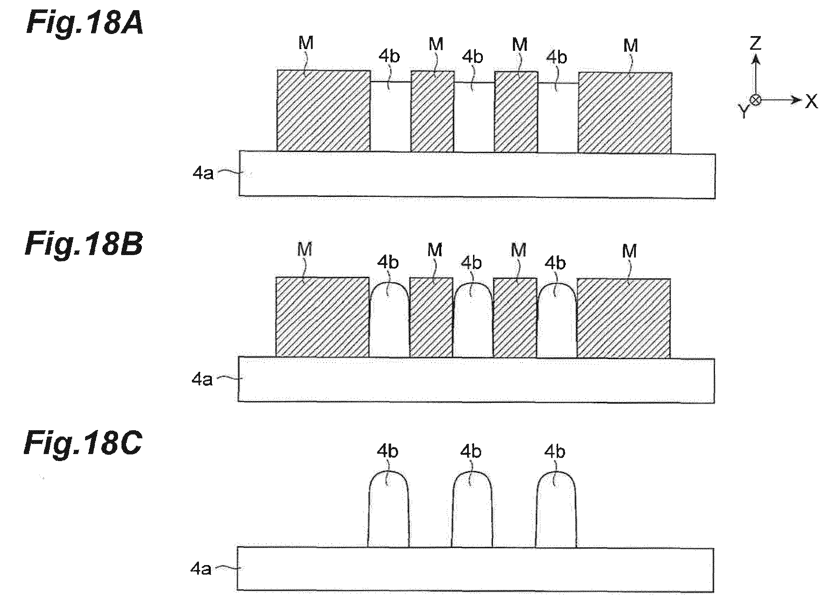

FIGS. 18A, 18B, and 18C are diagrams illustrating a cross-sectional configuration (XZ plane) of a thin film capacitor for describing a process of rounding a corner portion of a distal end of a projecting portion of the lower electrode.

In FIG. 13E, a process of rounding the distal end of the projecting portion 4b is performed when the projecting portion 4b of the lower electrode is formed. In FIG. 18A, after the mask M patterned by photolithography is first formed on the flat common electrode part 4a, the projecting portion 4b is formed within the opening pattern of the mask M. It is possible to use the plating or sputtering method in this formation, but the metal is assumed to be grown using the plating method here. The top surface of the projecting portion 4b is flat, but a process of rounding the top surface from the top surface to a deep portion is performed. For example, a method (a sputtering method and a milling method) of rounding the top surface by causing a rare gas such as Ar to collide with the top surface, a method of rounding the top surface by performing dry etching or wet etching on the top surface, or the like is used. That is, the contour in the XZ section of the top surface has a shape in which a convex arc is formed at the top by removing a peripheral part of the projecting portion top surface more than a center part (FIG. 18B).

Also, the metal can be etched with a suitable acid. For example, a sulfuric acid or hydrogen peroxide etching solution is well known as an etchant for copper, and the metal can be etched by merely sputtering metal atoms with a rare gas as dry etching using plasma or the like, but techniques of etching the metal while utilizing the oxidation of copper by employing a hydrocarbon gas or a halogen gas or incorporating oxygen therein are also well known.

After this process, a side surface of the projecting portion 4b is exposed by removing the mask M including a resist using an organic solvent or the like (FIG. 18C). Also, after the side surface of the projecting portion 4b is exposed, the metal material constituting the projecting portion 4b is heated at a softening temperature and a surface thereof may be leveled.

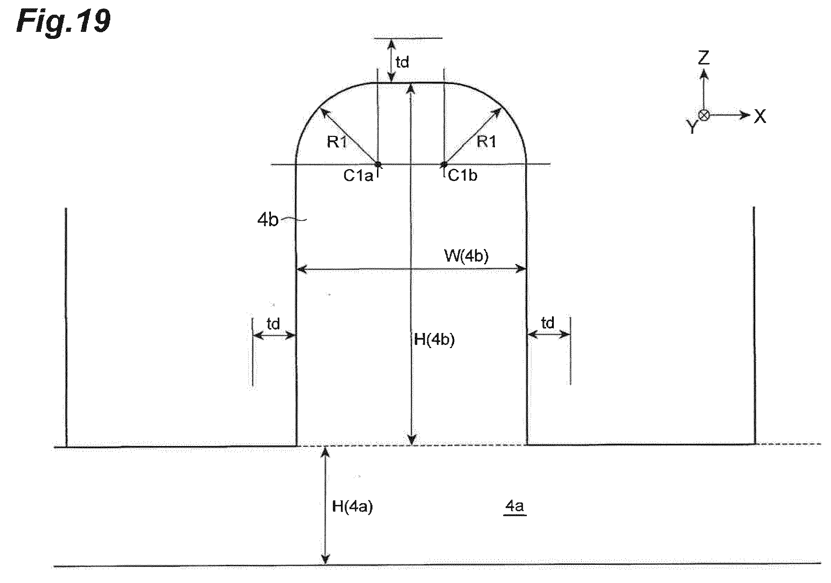

FIG. 19 is a diagram illustrating a cross-sectional configuration (XZ plane) of the projecting portion of the lower electrode.

When the etching is performed as described above, a part of the top surface exposed during etching is deformed so that the corner portion positioned in the outer edge of the top surface of the projecting portion is formed in an arc shape within the XZ plane. Of course, the top surface is deformed so that the corner portion is formed in an arc shape even in the YZ plane. Also, when the projecting portion 4b is viewed in a direction vertical to the XZ plane or the YZ plane, the degree of deformation of the corner portion is left-right symmetry. Although the centers of curvature of the arcs of the corner portions in FIG. 19 are denoted by C1a and C1b, the centers of curvature are positioned inside the projecting portion 4b.

The conditions of parameters for one projecting portion 4b within the XZ plane are as follows. Also, the thickness of the dielectric thin film 5 (see FIGS. 13F to 13I) formed on the projecting portion 4b of the lower electrode is assumed to be td.

First, the radius R1 of curvature of the corner portion satisfies $0.4 \times td \leq R1 \leq 20 \times td$. In this example, $56 \text{ nm} \leq R1 \leq 2800 \text{ nm}$ when the range is represented by an absolute value because the thickness td of the dielectric thin film 5 = 140 nm.

According to this thin film capacitor, the antenna effect increases, an electric field is concentrated on the dielectric thin film, and an internal defect of the dielectric thin film occurs while an element is used when the radius R1 of curvature is less than 0.4 times the thickness td of the dielectric thin film. When the radius R1 of curvature is greater than 20 times the thickness td of the dielectric thin film, the antenna effect is degraded, but malfunctions such as the stress applied in the in-plane direction of the dielectric thin film in the corner portion increasing and cracks tending to be introduced into the dielectric thin film or the concentration of an electric field due to a crystalline grain boundary tending to occur in the corner portion occur.

More preferably, the radius R1 of curvature of the corner portion satisfies $0.5 \times td \leq R1 \leq 10 \times td$. When this range is represented by an absolute value, $70 \text{ nm} \leq R1 \leq 140 \text{ nm}$ is given. In this case, the internal defect of the dielectric thin film is suppressed more than in the case of the above-described range of R1 and malfunctions such as cracks tending to be introduced into a crystalline grain boundary of the dielectric thin film due to stress in the in-plane direction of the dielectric thin film in the corner portion or the concentration of an electric field due to a crystalline grain boundary of the electrode tending to occur in the corner portion are also reduced.

Also, because the thickness td of the dielectric thin film is constant, a downward projecting portion of the upper electrode 6 is formed along a shape of a recess portion between projecting portions 4b of the lower electrode and a recess portion recessed upward between the projecting portions 6b of the upper electrode is formed along a shape of the projecting portion 4b of the lower electrode (see FIG. 12).

Next, a height H (4b) from the bottom surface of the recess portion adjacent to the projecting portion 4b and a height (thickness) H (4a) of the common electrode part 4a are included as parameters. As an example, H (4b) = 8 $\mu$m is set and H (4a) = 2 $\mu$m is set. A width within the XZ plane of the projecting portion 4b is W (4b) and the projecting portion 4b more projects to have a shape similar to an extended finger when an aspect ratio AR = H (4b)/W (4b) in the XZ plane of the projecting portion 4b more increases. A preferable range of the aspect ratio AR = H (4b)/W (4b) becomes $0.3 \leq AR \leq 10$. This is because the stress applied in the in-plane direction of the dielectric thin film in the top portion of the projecting portion 4b occurs, cracks tend to be introduced into the dielectric thin film, and the concentration of the electric field due to the crystalline grain boundary of the electrode in the top portion occurs when the AR is less than a lower limit and because the projecting portion 4b serves as the antenna, the concentration of the electric field occurs in the top portion of the projecting portion 4b, and the destruction of the dielectric thin film may occur due to the material of the dielectric thin film when the AR exceeds an upper limit.

Although the corner portion of the proximal end of the projecting portion 4b within the XZ plane is not smooth and is discontinuously bent, a method of smoothly rounding the corner portion can be adopted.

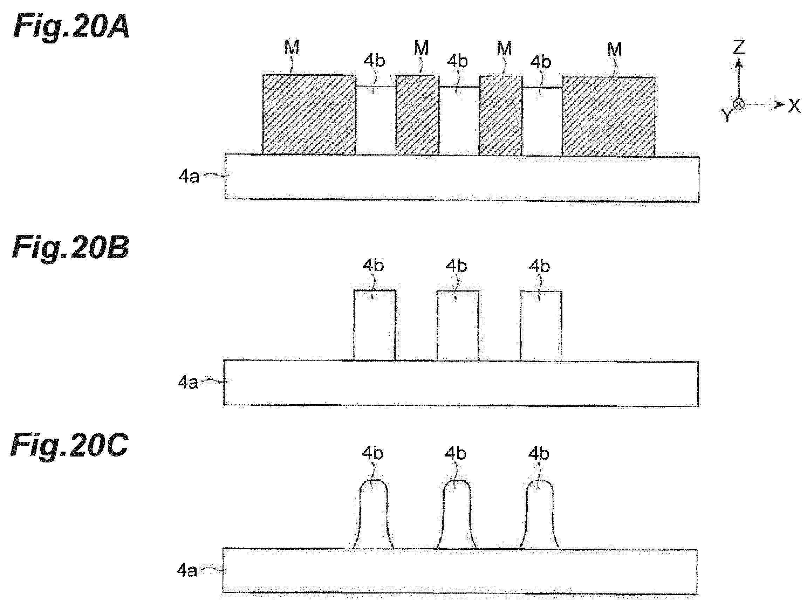

FIGS. 20A, 20B, and 20C are diagrams illustrating a cross-sectional configuration (XZ plane) of a thin film capacitor for describing a process of rounding corner portions of a distal end and a proximal end of a projecting portion of the lower electrode.

In FIG. 13E, a process of rounding the distal end of the projecting portion 4b is performed when the projecting portion 4b of the lower electrode is formed. In FIG. 20A, after the mask M patterned by photolithography is first formed on the flat common electrode part 4a, the projecting portion 4b is formed within the opening pattern of the mask M. It is possible to use the plating or sputtering method in this formation, but the metal is assumed to be grown using the plating method here. The top surface of the projecting portion 4b is flat.

Next, a side surface of the projecting portion 4b is exposed by removing the mask M including a resist using an organic solvent or the like (FIG. 20B).

Thereafter, a process of rounding corner portions for all exposed surfaces of the projecting portion 4b is performed. For example, a method (a sputtering method and a milling method) of rounding the corner portion of an outer edge of the top surface or the corner portion of the proximal end by causing a rare gas such as Ar to collide with the top surface, a method of rounding the corner portions of the surfaces by performing dry etching or wet etching on the corner portions, or the like is used. That is, the contour in the XZ section of the top surface has a shape in which a convex arc is formed at the top by removing a peripheral part of the projecting portion top surface more than a center part (FIG. 20B). Also, the contour in the XZ section of the proximal end of the projecting portion is formed in an arc shape in which the edge spreads by gradually removing the vicinity and the side surface of the corner portion (space) of the proximal end of the projecting portion (FIG. 20C).

Also, the metal can be etched with a suitable acid. For example, a sulfuric acid or hydrogen peroxide etching solution is well known as an etchant for copper, and the metal can be etched by merely sputtering metal atoms with a rare gas as dry etching using plasma or the like, but techniques of etching the metal while utilizing the oxidation of copper by employing a hydrocarbon gas or a halogen gas or incorporating oxygen therein are also well known.

Also, before and/or after the process of FIG. 20B and/or FIG. 20C, the metal material constituting the projecting portion 4b is heated at a softening temperature and a surface thereof may be leveled.

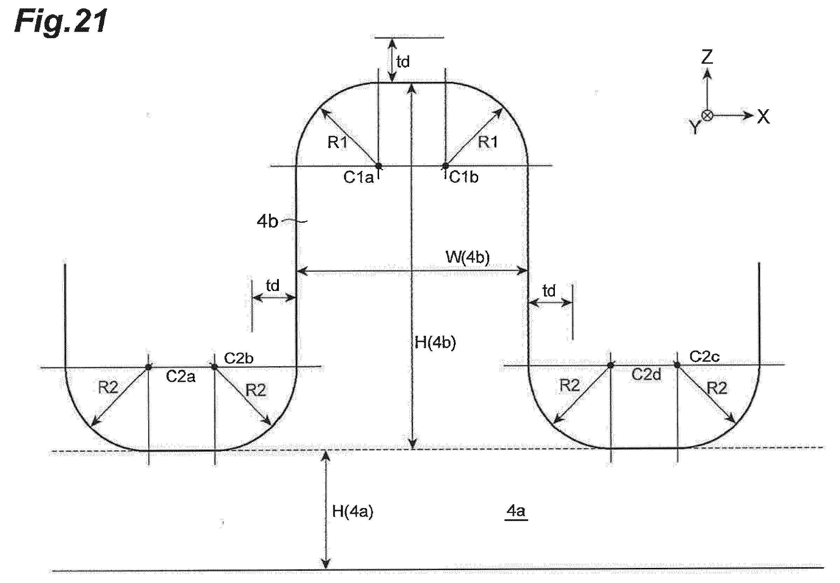

FIG. 21 is a diagram illustrating a cross-sectional configuration (XZ plane) of the projecting portion of the lower electrode.

The projecting portion of FIG. 21 is different from the projecting portion illustrated in FIG. 19 in that the shape of the corner portion of the proximal end of the projecting portion is smoothly concaved and the remaining elements are the same. Also, the range of the parameters and the action and effect are also the same as in the case of FIG. 19. In terms of the proximal end, all exposed surfaces exposed during etching are etched in the etching of FIG. 13E and the corner portion positioned at the proximal end of the projecting portion is deformed so that an arc shape in which the edge spreads is formed. Of course, the proximal end is deformed so that the corner portion is formed in an arc shape in which the edge spreads even in the YZ plane. Also, when the projecting portion 4b is viewed in a direction vertical to the XZ plane or the YZ plane, the degree of deformation of the corner portion is left-right symmetry. Centers of curvature of arcs of corner portions at both sides of the proximal end are denoted by C2a, C2b, C2c, and C2d in FIG. 21, but these centers of curvature are positioned outside the projecting portion 4b (within the recess portion).

The conditions of parameters for the proximal end of one projecting portion 4b within the XZ plane are as follows.

First, the radius R2 of curvature of the corner portion of the left/right of the proximal end of the projecting portion 4b (radii of curvature in bottom portions of the recess portion positioned at both sides of the recess portion 4b) satisfies $0.4 \times td \leq R2 \leq 20 \times td$. In this example, $56\ nm \leq R2 \leq 2800\ nm$ when the range is represented by an absolute value because the thickness td of the dielectric thin film 5 = 140 nm.

According to this thin film capacitor, the antenna effect increases and an electric field is concentrated on the dielectric thin film, and an internal defect of the dielectric thin film in the vicinity of the proximal end occurs while an element is used when the radius R2 of curvature is less than 0.4 times the thickness td of the dielectric thin film. When the radius R2 of curvature is greater than 20 times the thickness td of the dielectric thin film, the antenna effect is degraded, but malfunctions such as the stress applied in the in-plane direction of the dielectric thin film in the corner portion increasing and cracks tending to be introduced into the dielectric thin film or the concentration of an electric field due to a crystalline grain boundary of the electrode tending to occur in the corner portion occur.

More preferably, the radius R2 of curvature of the corner portion satisfies $0.5 \times td \leq R2 \leq 10 \times td$. When this range is represented by an absolute value, $70\ nm \leq R2 \leq 140\ nm$ is given. In this case, the internal defect of the dielectric thin film is suppressed more than in the case of the above-described range of R2 and malfunctions such as cracks tending to be introduced into the dielectric thin film due to stress in the in-plane direction of the dielectric thin film in the corner portion or the concentration of an electric field due to a crystalline grain boundary of the electrode tending to occur in the corner portion are also reduced.

Also, because the thickness td of the dielectric thin film is constant, a downward projecting portion of the upper electrode 6 is formed along a shape of a recess portion between projecting portions 4b of the lower electrode and a recess portion recessed upward between the projecting portions 6b of the upper electrode is formed along a shape of the projecting portion 4b of the lower electrode (see FIG. 1).

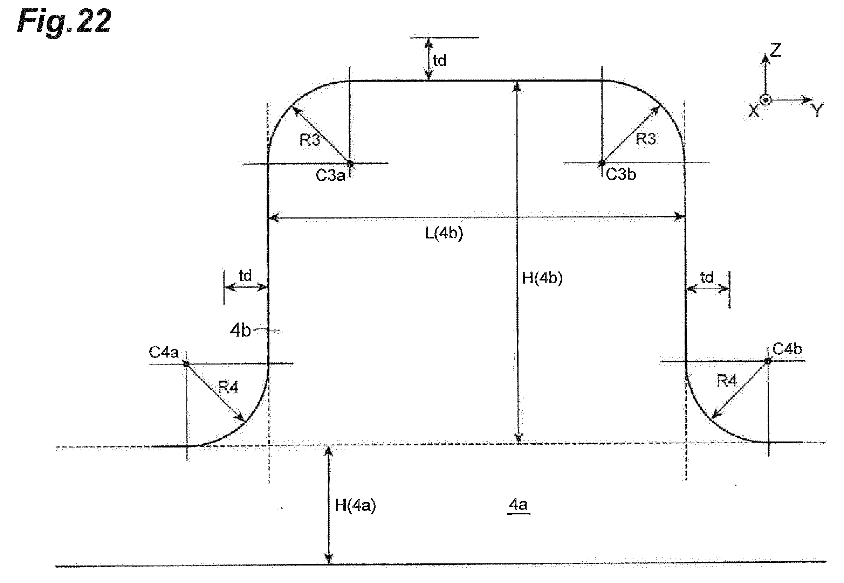

FIG. 22 is a diagram illustrating a cross-sectional configuration (YZ plane) of the projecting portion of the lower electrode.

The section (YZ section) of FIG. 22 is a section vertical to the section (XZ section) of FIG. 21. Although the Y-axis direction length of the projecting portion 4b is longer than the Y-axis direction length in FIG. 21, a basic round shape is the same as that illustrated in FIG. 21.

In etching in FIG. 13E, all exposed surfaces exposed during etching are etched, a corner portion of a distal end of the projecting portion 4b is deformed to be formed in an arc, and a corner portion positioned at a proximal end is deformed to be formed in an arc shape in which the edge spreads. The degree of deformation of the corner portion is left-right symmetry. Although the centers of curvature of arcs of corner portions at both sides of the proximal end are denoted by C3a and C3b in FIG. 22, the centers of curvature are positioned inside the projecting portion 4b. Also, although the centers of curvature of arcs of corner portions at both sides of the proximal end are denoted by C4a and C4b, the centers of curvature are positioned outside the projecting portion 4b.

The conditions of parameters for the proximal end of one projecting portion 4b within the XZ plane are as follows.

First, the radius R3 of curvature of the corner portion of the left/right of the distal end of the projecting portion 4b satisfies $0.4 \times td \leq R3 \leq 20 \times td$. In this example, 56 nm $\leq$ R3 $\leq$ 2800 nm when the range is represented by an absolute value because the thickness td of the dielectric thin film 5 = 140 nm.

According to this thin film capacitor, the antenna effect increases and an electric field is concentrated on the dielectric thin film, and an internal defect of the dielectric thin film occurs while an element is used when the radius R3 of curvature is less than 0.4 times the thickness td of the dielectric thin film. When the radius R3 of curvature is greater than 20 times the thickness td of the dielectric thin film, the antenna effect is degraded, but malfunctions such as the stress applied in the in-plane direction of the dielectric thin film in the corner portion increasing and cracks tending to be introduced into the dielectric thin film or the concentration of an electric field due to a crystalline grain boundary of the electrode tending to occur in the corner portion occur.

More preferably, the radius R3 of curvature of the corner portion satisfies $0.5 \times td \leq R3 \leq 10 \times td$. When this range is represented by an absolute value, 70 nm $\leq$ R3 $\leq$ 140 nm is given. In this case, the internal defect of the dielectric thin film is suppressed more than in the case of the above-described range of R3 and malfunctions such as cracks tending to be introduced into the dielectric thin film due to stress in the in-plane direction of the dielectric thin film in the corner portion or the concentration of an electric field due to a crystalline grain boundary of the electrode tending to occur in the corner portion are also reduced.

First, the radius R4 of curvature of the corner portion of the left/right of the proximal end of the projecting portion 4b satisfies $0.4 \times td \leq R4 \leq 20 \times td$. In this example, 56 nm $\leq$ R4 $\leq$ 2800 nm when the range is represented by an absolute value because the thickness td of the dielectric thin film 5 = 140 nm.

According to this thin film capacitor, the antenna effect increases, an electric field is concentrated on the dielectric thin film, and an internal defect of the dielectric thin film in the vicinity of the proximal end occurs while an element is used when the radius R4 of curvature is less than 0.4 times the thickness td of the dielectric thin film. When the radius R4 of curvature is greater than 20 times the thickness td of the dielectric thin film, the antenna effect is degraded, but malfunctions such as the stress applied in the in-plane direction of the dielectric thin film in the corner portion increasing and cracks tending to be introduced into the dielectric thin film or the concentration of an electric field due to a crystalline grain boundary of the electrode tending to occur in the corner portion occur.

More preferably, the radius R4 of curvature of the corner portion satisfies $0.5 \times td \leq R4 \leq 10 \times td$. When this range is represented by an absolute value, 70 nm $\leq$ R4 $\leq$ 140 nm is given. In this case, the internal defect of the dielectric thin film is suppressed more than in the case of the above-described range of R4 and malfunctions such as cracks tending to be introduced into the dielectric thin film due to stress in the in-plane direction of the dielectric thin film in the corner portion or the concentration of an electric field due to a crystalline grain boundary of the electrode tending to occur in the corner portion are also reduced.

Also, the length of the projecting portion 4b in the Y-axis direction in the YZ plane is set to L (4b). An aspect ratio AR' = H (4b)/L (4b) in the YZ plane of the projecting portion 4b is not particularly limited. However, the capacitance per unit area increases if a height H (4b) increases and the mechanical strength of the Y-axis direction increases as the length L (4b) increases. Also, a plurality of projecting portions 4b can be arranged on dots in the Y-axis direction. In this case, the length L (4b) decreases, and the capacitance per unit area increases.

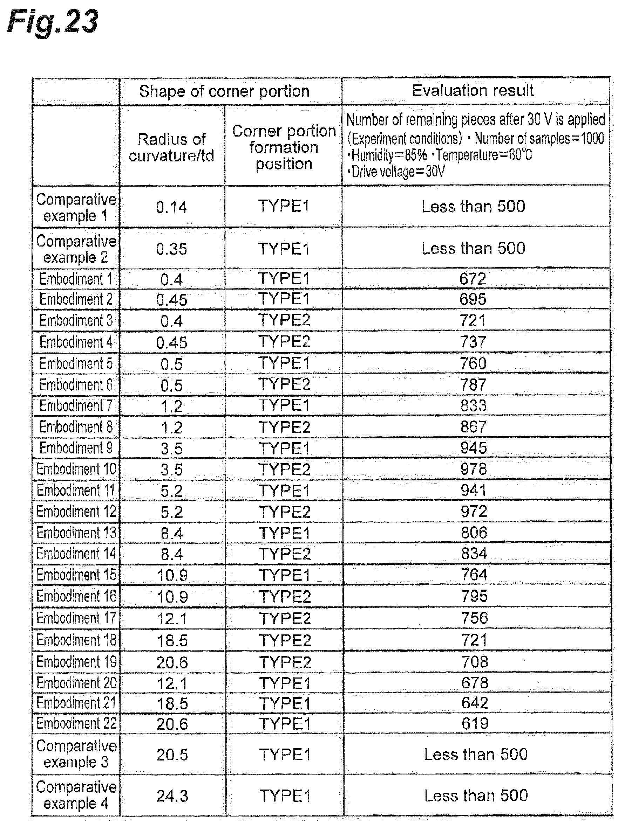

FIG. 23 is a chart illustrating a relation between a shape of a corner portion and an evaluation result in experiment examples (an embodiment and a comparative example) in the second type of invention. Hereinafter, experiment examples in the second type of invention will be described.

Embodiments 1 to 22 and comparative examples 1 to 4 are shown. TYPE 1 indicates the case in which a position at which the corner portion is rounded is only a distal end as illustrated in FIG. 19 and TYPE 2 indicates the case in which a position at which the corner portion is rounded is a proximal end as well as a distal end as illustrated in FIG. 21.

The common electrode part 4a and the projecting portion 4b are made of Cu and grown by a plating method. In this etching, using a 5 wt% aqueous solution of ferric chloride and using alumina formed by an ALD method as the dielectric thin film 5, an upper electrode made of Cu was formed thereon by a sputtering method.

Also, H (4a) = 2 $\mu$m, H (4b) = 8 $\mu$m, W (4b) = 4 $\mu$m, L (4b) = 112 $\mu$m, and td = 140 nm.

The plurality of thin film capacitors described above were formed within a single chip and the tolerance of each capacitor was measured. A Y-axis direction length (width) of the manufactured thin film capacitor is 0.1 mm and an X-axis direction length (length) is 0.4 mm. 1000 samples of each example were formed on the same Si wafer. The thickness of the wafer (substrate) is 2 mm, the thickness of the stress adjustment layer is 1 $\mu$m, and a material of the dielectric thin film sandwiched between the upper electrode and the lower electrode is $Al_2O_3$ manufactured by an ALD method and has a thickness of 140 nm (1400 Å). Materials of the upper electrode and the lower electrode are the same, the thicknesses of the common electrode parts thereof are the same (2 $\mu$m), the pitch of the uneven surface structure is 4 $\mu$m, the height H of the projecting portion in each uneven surface structure is 8 $\mu$m, the material of the protective film configured to cover the upper electrode is polyimide, and the plating of Ni and Au is performed on Cu for the connection electrode passing through the inside of the protective film, a contact electrode positioned at a termination end of the connection electrode, or the under bump metal. These electrodes were prepared using a plating method.

1000 samples were prepared for each experiment example and a voltage of 30 V was continuously applied between the upper and lower electrodes under an environment of 85% humidity and a temperature of 85°C. After the environmental test for 24 hours, a sample having an insulation resistance of $10^{11}$ $\Omega$ or more was designated as a normal product and a sample having an insulation resistance of less than $10^{11}$ $\Omega$ was designated as a defective product.

Etching was performed so that the radii R1, R2, R3, and R4 of curvature of the examples were substantially the same. A 5 wt% aqueous solution of ferric chloride was used and an etching time was 45 sec to 100 sec. An etching rate of a thickness direction of the substrate can be controlled by means of a temperature of an etching agent, the adjustment of an etching time, a pressure by ultrasonic waves, or the like, and an etching rate of a direction vertical to the thickness direction can be controlled by the adjustment of an aqueous solution concentration of an etching agent. In embodiments 1 to 22 including TYPE 1 and TYPE 2, at least the radii R1 and R3 of curvature of corner portions of the distal end satisfy $0.4 \times td \leq R1 \leq 20 \times td$ and $0.4 \times td \leq R3 \leq 20 \times td$. In this case, a result indicated that the number of normal products among 1000 samples was 619 to 978. In the cases of comparative examples 1 to 4, the number of normal products was less than or equal to 500 after 24 hours. Therefore, it can be seen that the embodiment is superior to the comparative example.

Also, TYPE 1 is embodiments 1, 2, 5, 7, 9, 11, 13, 15, 20, 21, and 22 and TYPE 2 is embodiments 3, 4, 6, 8, 10, 12, 14, 16, 17, 18, and 19. Comparative examples 1 to 5 were set as TYPE 1.

In the case of TYPE 2 (embodiments 3, 4, 6, 8, 10, 12, 14, 16, 17, and 18), a ratio of normal products increases more than in thin film capacitors of TYPE 1 (embodiments 1, 2, 5, 7, 9, 11, 13, 15, 20, 21, and 22) having the same radius of curvature. Therefore, it can be seen that TYPE 2 is superior to TYPE 1.

In the case of embodiments 5 to 16 ($0.5 \times td \leq$ radius of curvature $\leq 10 \times td$), the number of normal products is 760 to 945. In this case, the number of normal products is greater than the number of normal products (619 to 756) in the cases of embodiments 1 to 4 and embodiments 17 to 22 ($0.4 \times td \leq$ radius of curvature $\leq 0.45 \times td$ and $12.1 \times td \leq$ radius of curvature $\leq 20.6 \times td$). Therefore, it is further preferable that the radius of curvature be ($0.5 \times td \leq$ radius of curvature $\leq 10 \times td$).

As described above, it is possible to increase capacitance because the thin film capacitor having an uneven surface structure is a structure in which an area opposite to the electrode in a unit volume increases. On the other hand, because the electrode is subdivided, the strength is degraded, a mechanical force generated by a temperature increase during mounting or an environment during actual use is transferred to a dielectric layer and the dielectric layer may be destroyed. In this embodiment, this destruction is suppressed. A lower electrode in which the shape of the vertical cross section is a comb tooth or slit shape or a lower electrode in which the shape of the vertical cross section is a shape including a pin or hole can be used as the uneven surface structure of the lower electrode, and the structures of the lower electrode and the upper electrode can also be replaced with each other.

As described above, it is possible to suppress stress accumulation for the dielectric thin film and suppress the characteristic deterioration by satisfying the above-described predetermined conditions.

Next, an overview of a third type of invention will be described.

In the third type of invention, a thin film capacitor of a first aspect is a thin film capacitor including: a substrate; an insulating layer formed on a main surface of the substrate; a lower electrode formed on the insulating layer; a dielectric thin film configured to cover the lower electrode; an upper electrode formed on the dielectric thin film; a first terminal provided in the lower electrode; and a second terminal provided in the upper electrode, wherein, when an XYZ three-dimensional coordinate system is set, the main surface is an XY plane, and a direction in which the first terminal and the second terminal are connected is designated as an X-axis, the lower electrode has an uneven surface structure and a longitudinal direction of a top surface of the projecting portion of the uneven surface structure is in the X-axis direction.

According to this thin film capacitor, it is possible to increase the capacitance per unit area because the lower electrode has an uneven surface structure. When a bias voltage is applied between a first terminal and a second terminal, charge is accumulated in the thin film capacitor. When the applied voltage is an alternating current voltage, an alternating current flows between the terminals. Here, equivalent series resistance (ESR) of the thin film capacitor is considered. Also, the ESR is given as the square root of $Z^2$-$X^2$ when impedance Z and equivalent reactance X are used.

The ESR increases when a resistance length is long and decreases when the resistance length is short. However, when the ESR increases, the loss of power based on resistance occurs and a circuit operation may be unstable. Therefore, it is preferable to decrease the ESR. When the ESR is low, a Q value of the thin film capacitor becomes high.

In this thin film capacitor, the longitudinal direction of the top surface of the projecting portion of the uneven surface structure is in the X-axis direction (a direction in which the terminals are connected). This structure has lower ESR than when the longitudinal direction of the top surface extends along the Y axis. Therefore, according to the thin film capacitor, the ESR becomes low, the loss can be reduced, and the operation can be stable.

In a second thin film capacitor, the width of the projecting portion of the lower electrode in a Y-axis direction narrows from a proximal end to a distal end.

In this case, the impedance decreases and the ESR also decreases. The cause of this is not always clear, but the mutual inductance within the above-described lower electrode is considered to decrease. A structure in which the longitudinal direction of the top surface extends along the X axis is equivalent to a structure in which a plurality of signal lines are placed in parallel. Also, a high-frequency signal applied to the above-described lower electrode of the thin film capacitor of the present invention tends to be concentrated on each top surface edge of the projecting portion. Thus, the mutual inductance occurs between signals concentrated on each top surface edge in the above-described lower electrode. According to a structure in which a width in the Y-axis direction is narrowed from the proximal end to the distal end, a top surface edge interval between one projecting portion and another projecting portion is widened. Simultaneously, the angle of the top surface edge becomes gentle and the concentration of a signal is mitigated. Thus, the mutual inductance occurring between a plurality of projecting portions of the lower electrode decreases. Therefore, the loss can be further reduced and the operation can be stable.

In a third thin film capacitor, when a ratio between a Y-axis direction width W1 of the proximal end of the projecting portion of the lower electrode and a Y-axis direction width W2 of the distal end of the projecting portion of the lower electrode is RW = W1/W2, the ratio RW satisfies the relational expression $1.2 \leq RW \leq 1.9$.

When RW is less than 1.2, the impedance increases, the current of an electrode surface is unlikely to flow, and there is room for improvement in the reduction of the ESR because the concentration of the high-frequency signal in the top surface edge portion of the above-described projecting portion is excessively large and it is difficult to decrease the mutual impedance between projecting portions of the lower electrode. When RW is greater than 1.9, the concentration of the signal is mitigated in the projecting portion, but signal propagation from one projecting portion to another projecting portion tends to occur. Because impedance occurs due to this signal propagation in a horizontal direction, there is also room for improvement in the reduction of the ESR.

According to the thin film capacitor of the present invention, it is possible to decrease loss and increase stability.

Hereinafter, the thin film capacitor according to the embodiment related to the third type of invention will be described. Also, the same reference signs are assigned to the same elements and redundant description thereof will be omitted. Also, an XYZ three-dimensional orthogonal coordinate system is set and the thickness direction of the substrate is assumed to be the Z-axis direction.

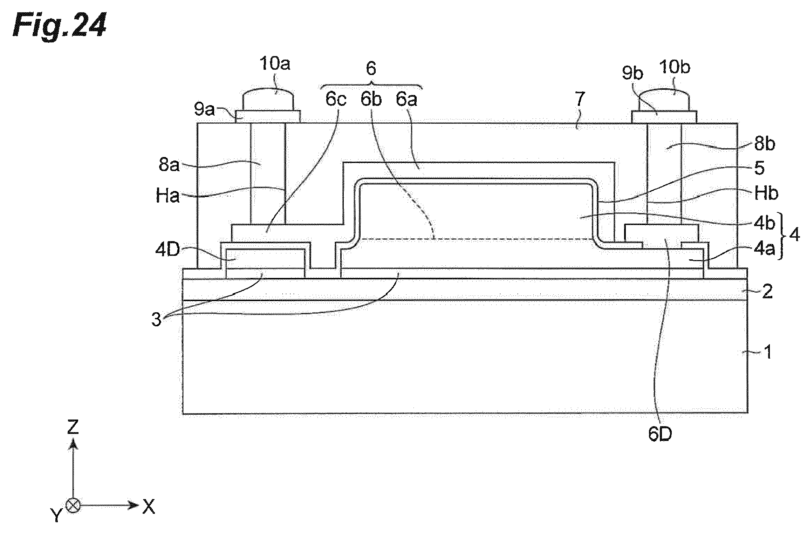

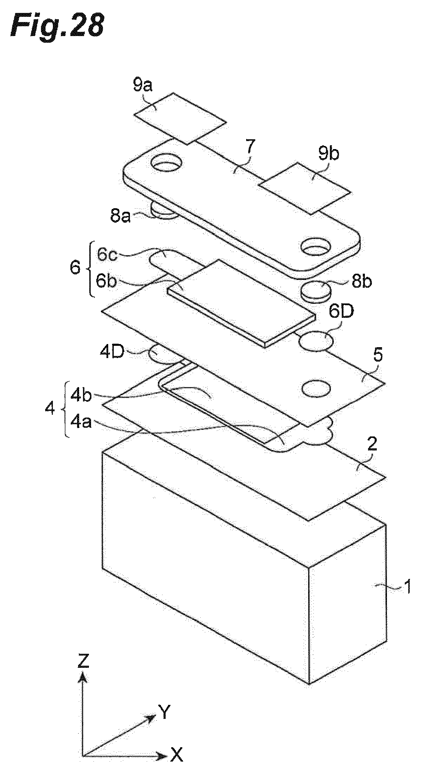

FIG. 24 is a diagram illustrating a vertical cross-sectional configuration of a thin film capacitor according to an embodiment. Also, FIG. 28 is an exploded perspective view of a thin film capacitor, but some parts such as a base layer and a protective film in FIG. 24 are omitted to clearly describe the structure. In the following description, FIGS. 24 and 28 will be appropriately referred to.

This thin film capacitor includes a substrate 1, an insulating layer 2 (stress adjustment layer 2) formed on a main surface (XY plane) of the substrate 1, a lower electrode 4 formed on the stress adjustment layer 2 via a base layer 3, a dielectric thin film 5 configured to cover the lower electrode 4, and an upper electrode 6 formed on the dielectric thin film 5.

A main part of the thin film capacitor is constituted of the lower electrode 4, the upper electrode 6, and the dielectric thin film 5 positioned between the lower electrode 4 and the upper electrode 6.

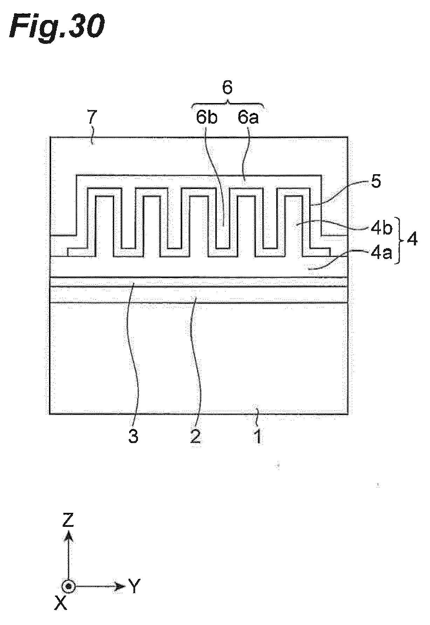

The lower electrode 4 includes the common electrode part 4a extending in parallel to the main surface of the substrate 1 and a plurality of projecting portions 4b extending to project from the common electrode part 4a away from the substrate 1. Also, the longitudinal direction of the top surface of the projecting portion 4b of the uneven surface structure is in the X-axis direction and the uneven surface structure is observed within the YZ section as illustrated in FIG. 30. Likewise, the upper electrode 6 includes a common electrode part 6a extending in parallel to the main surface of the substrate 1 and a plurality of projecting portions 6b extending to project toward the substrate 1 from the common electrode part 6a. In relation to a structure of a single projecting portion, the structure of the projecting portion 6b of the upper electrode 6 is a structure of a mirror image relation with the projecting portion 4b of the lower electrode 4 for the XY plane and mutual positions of the projecting portion are shifted in the Y-axis direction so that positions of the mutual projecting portions are positioned within the mutual recess portions. Therefore, the longitudinal direction of the top surface of the projecting portion 6b of the upper electrode 6 is in the X-axis direction (see FIG. 30). In addition, the upper electrode 6 has a contact portion 6c for enabling the connection electrode to come in contact with an external terminal.

The lower electrode 4 has an uneven surface structure of a vertical cross section (YZ plane) in the thickness direction of the substrate 1 and has a comb tooth shape as illustrated in FIG. 30. Likewise, the upper electrode 6 has an uneven surface structure of a vertical cross section (YZ plane) in the thickness direction of the substrate 1 and has a comb tooth shape. The projecting portion 6b projecting to the lower electrode side of the upper electrode 6 is positioned in a gap between the projecting portions 4b of the lower electrode 4 and a structure in which comb teeth face each other and engaged with each other is a trench structure in the vertical cross section and increases capacitance per unit area.

This thin film capacitor includes a protective film 7 configured to cover the upper electrode 6, a dummy electrode 4D formed on the stress adjustment layer 2, and a lower contact electrode 6D formed on the common electrode part 4a of the lower electrode 4 and in contact with the common electrode part 4a. The dummy electrode 4D is formed simultaneously with the common electrode part 4a of the lower electrode and the lower contact electrode 6D is formed simultaneously with the upper electrode 6.

On the left in FIG. 24 or 28 of the thin film capacitor, the dielectric thin film 5, the contact portion 6c of the upper electrode 6, and a second terminal 8a (connection electrode) are positioned on the dummy electrode 4D. On the other hand, on the right in FIG. 24 or 28 of the thin film capacitor, the lower contact electrode 6D in contact with the common electrode part 4a and a second terminal 8a (connection electrode) are positioned on the common electrode part 4a of the lower electrode 4 via an opening provided in the dielectric thin film 5. The dummy electrode 4D has the same thickness as the common electrode part 4a of the lower electrode 4.

Also, the second terminal 8a is positioned within a first contact hole Ha provided in the protective film 7 and the first terminal 8b is positioned within a second contact hole Hb provided in the protective film 7.

In the case of this structure, because the dummy electrode 4D has the same thickness as the common electrode part 4a of the lower electrode 4, heights of the second terminal 8a and the first terminal 8b in the thickness direction can be approximately the same and a thin film capacitor of a flat structure can be formed.

A contact electrode and/or an under bump metal 9a are in contact with the second terminal 8a and are positioned on the second terminal 8a. A contact electrode and/or an under bump metal 9b are in contact with the first terminal 8b and are positioned on the first terminal 8b. Bumps 10a and 10b are arranged on the under bump metals 9a and 9b, respectively.

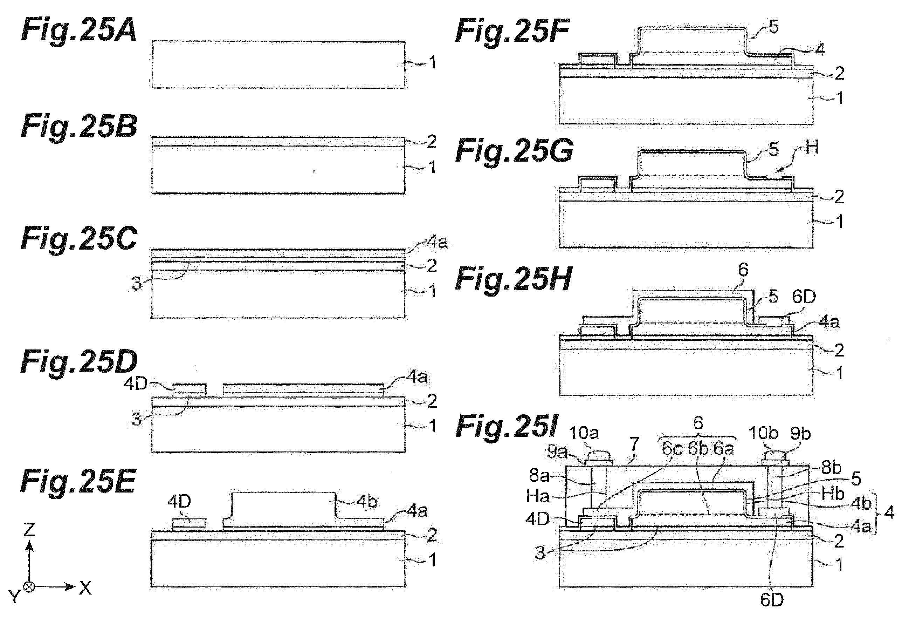

FIGS. 25A, 25B, 25C, 25D, 25E, 25F, 25G, 25H, and 25I are diagrams illustrating a process of manufacturing a thin film capacitor.

First, as in FIG. 25A, the substrate 1 is prepared. Although an insulator or a semiconductor can be used as a substrate material, Si is used as the substrate material in view of ease of working and processing in this example.

Next, as in FIG. 25B, the stress adjustment layer 2 is formed on the substrate 1. The formation method includes a sputtering method, a vapor deposition method, a chemical vapor deposition (CVD) method, etc. according to a material. In this example, because silicon nitride (SiNx) is used as the stress adjustment layer 2 (x is a proper natural number and $Si_3N_4$ or the like is mainly used), the sputtering method targeting the silicon nitride is used as the formation method.

Thereafter, as in FIG. 25C, the base layer 3 is formed on the stress adjustment layer 2 and then the initial common electrode part 4a of the lower electrode is formed on the stress adjustment layer 2. A method of forming the above-described elements includes a sputtering method, a vapor deposition method, a plating method, etc. Both the base layer 3 and the initial common electrode part 4a (lower electrode) contain copper (Cu) as a main component (an atomic percentage is 50% or more), and a material for increasing the adhesive strength such as Cr can be mixed with the base layer 3 as necessary.

Next, as in FIG. 25D, the initial common electrode part 4a and the base layer 3 are patterned according to photolithography and a part is separated from a main body part and designated as a dummy electrode 4D. That is, a mask in which a part to be removed by performing etching is opened is formed on the initial common electrode part 4a and the mask is removed after etching is performed via the mask. In addition to wet etching, a dry etching method such as an Ar milling method or a reactive ion etching (RIE) method can be used as the etching. In the wet etching of copper, hydrogen peroxide or the like can be used.

Next, as in FIG. 25E, a comb tooth part including a plurality of projecting portions 4b is formed on the common electrode part 4a. The plurality of projecting portions 4b are patterned according to photolithography. That is, a mask in which a part for growing a plated layer serving as the projecting portion 4b is opened is formed on the common electrode part 4a and the mask is removed after the projecting portion 4b is grown within the opening of the mask. Alternatively, the plated layer serving as the projecting portion 4b is formed on the common electrode part 4a, the mask is formed on the common electrode part 4a, the opening of the mask is etched to leave the projecting portion 4b, and then the mask is removed. Also, a process of rounding the corner portion of the projecting portion 4b or forming the projecting portion 4b in a tapered shape is performed.

Next, as in FIG. 25F, a dielectric thin film 5 is formed on the lower electrode 4 and the dummy electrode 4D. Although the dielectric thin film 5 of this example is $Al_2O_3$, another dielectric such as MgO or $SiO_2$ may be used. A method of forming the dielectric thin film 5 includes a sputtering method, a CVD method, or an atomic layer deposition (ALD) method. For example, it is possible to use a sputtering method targeting alumina, but the ALD method of alternately supplying trimethyl aluminum (TMA) which is an Al raw material and $H_2O$ which is an O raw material on the substrate surface is used in this example.

Next, as in FIG. 25G, a contact hole H is formed in a part of the dielectric thin film 5 using photolithography technology. Dry etching or wet etching can be used in the formation. The Ar milling can be used as the dry etching.

Thereafter, as in FIG. 25H, using the photolithography technology, a mask is formed on the dielectric thin film and the upper electrode 6 and the lower contact electrode 6D are simultaneously formed on the dielectric thin film 5 via the opening of the mask. Because a part of the dielectric thin film 5 is opened through a contact hole, a part of the lower electrode 4 is connected to the lower contact electrode 6D and the remaining part of the upper electrode 6 forms a main body part of the capacitor with the lower electrode and the dielectric thin film. In the formation, it is possible to use the sputtering method, the vapor deposition method, and the plating method. The upper electrode 6 contains copper (Cu) as a main component (an atomic percentage is 50% or more).

Next, as in FIG. 25I, the whole structure is covered with the protective film 7, the mask is formed on the protective film 7 using the photolithography technology, two openings are made in the mask, and the contact holes Ha and Hb are formed by etching the insides of the two openings. Although it is only necessary for the protective film 7 to be an insulating material, a resin material (polyimide) is adopted in this example. It is possible to use a coating method based on a spin coater or the like in the formation. Next, the second terminal 8a and the first terminal 8b are embedded within the contact holes. When the materials of the second terminal 8a and the first terminal 8b have copper (Cu) as the main component, it is possible to use a vapor deposition method, a sputtering method, a plating method, or the like in a method of forming the above-described elements.

The under bump metal 9a and the under bump metal 9b serving as conductive pads are provided on the second terminal 8a and the first terminal 8b. These can function as contact electrodes and the under bump metal can be further provided on the contact electrode using a different material. Bumps 10a and 10b are arranged on the under bump metals 9a and 9b, respectively. Cu, Ni, and Au can be used as materials of the under bump metal or the contact electrode. These can be stacked or mixed for use for each material. Preferably, it is possible to perform plating of Ni and Au on Cu.

Also, if the vertical cross section has the uneven surface structure, various types are considered as the structure of the lower electrode 4. Also, a plurality of thin film capacitors like that described above can be formed on a single wafer and can be separately used by performing dicing individually or for a desired group.

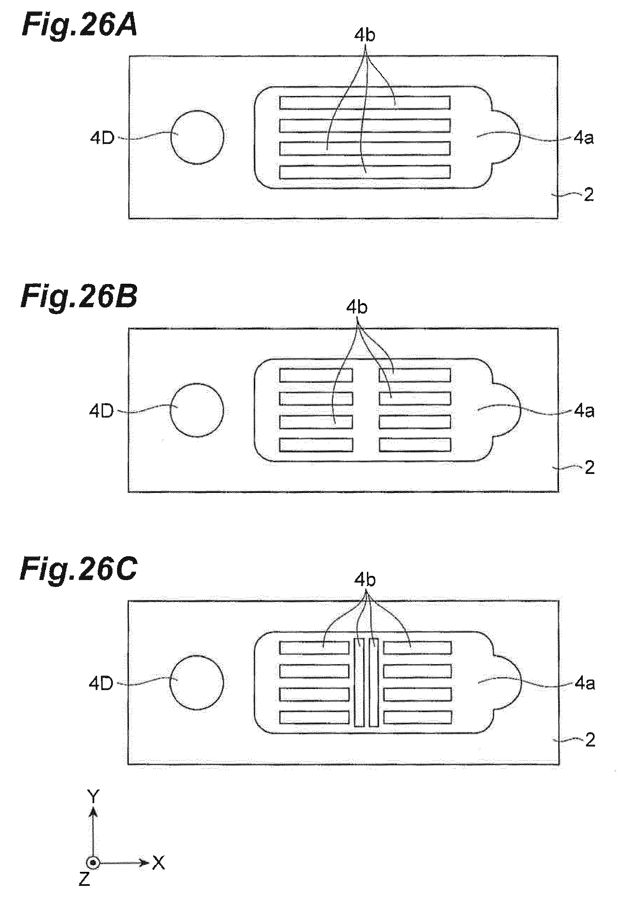

FIGS. 26A, 26B, and 26C are plan views of various lower electrodes 4 and dummy electrodes 4D. Also, output extraction electrodes (bumps 10a and 10b) of the capacitor in FIG. 24 are separated in the X-axis direction.

In the case of the structure of FIG. 26A, the lower electrode 4 has a plurality of projecting portions 4b projecting in the +Z-axis direction and in which a longitudinal direction of a top surface extends in the Y-axis direction. A groove is formed between the projecting portions 4b. A longitudinal direction of the groove is also the X-axis direction. The common electrode part 4a serving as a base is generally rectangular. Also, the dummy electrode 4D is separated from the common electrode part 4a.

In the case of the structure of FIG. 26B, the lower electrode 4 has a plurality of projecting portions 4b projecting in the +Z-axis direction and in which a longitudinal direction of a top surface extends in the X-axis direction, but the plurality of projecting portions 4b are separated to be aligned in two columns in the Y-axis direction. Also, the separation indicates that a surface position of the lower electrode positioned in a gap between the above-described columns is lowered to a height less than or equal to 50% of the height of the projecting portion from the common electrode part (the height from the bottom surface of the recess portion). In this example, the surface position of the gap between the columns of the projecting portions 4b (the gap in the Y-axis direction) is 0% (the height of the bottom surface of the recess portion of the lower electrode). A groove is formed between the projecting portions 4b. Although the longitudinal direction of the groove is also the X-axis direction, the gap between the above-described projecting portion columns also forms the recess portion when the adjacent projecting portion 4b is viewed in the Y-axis direction. Also, the common electrode part 4a serving as the base is generally rectangular. Also, the dummy electrode 4D is separated from the common electrode part 4a. In the case of this structure, the expansion/contraction in the longitudinal direction of the projecting portion 4b does not reach the entire common electrode part 4a even when thermal expansion occurs in the lower electrode 4. Thus, there is an advantage in that it is difficult for the dielectric thin film 5 to be destroyed.

The case of the structure of FIG. 26C is the same as the case of the structure of FIG. 26B in that the lower electrode 4 has a plurality of projecting portions 4b projecting in the +Z-axis direction and in which a longitudinal direction of a top surface extends in the X-axis direction and the plurality of projecting portions 4b are separated to be aligned in two columns in the Y-axis direction. The structure of FIG. 26C is only different from the structure of FIG. 26B in that a plurality of projecting portions 4b in which the top surface extends in the Y-axis direction are separately positioned in the gap between the above-described projecting portion columns. In the case of this structure, there is an advantage in that frequency selectivity similar to that of a so-called EBG element can be applied to the capacitor because a region in which the impedance and capacitance rapidly change is formed within the same capacitor surface.

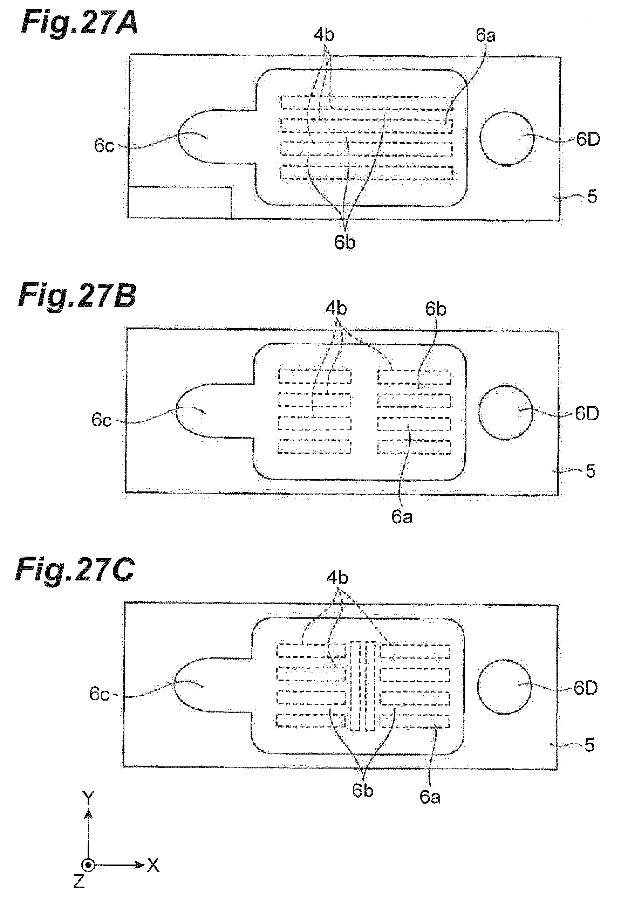

FIGS. 27A, 27B, and 27C are plan views of various upper electrodes and lower contact electrodes.

In the case of the structure of FIG. 27A, the upper electrode 6 has a plurality of projecting portions 6b projecting in the -Z-axis direction and in which the longitudinal direction of the top surface extends in the X-axis direction and the projecting portions 6b are formed between the projecting portions 4b. A groove recessed in the +Z-axis direction is formed between the projecting portions 6b and the projecting portion 4b is housed in the groove. The common electrode part 6a serving as the base is generally rectangular, the contact portion 6c extends in the -X-axis direction from one end of the common electrode part 6a, and the lower contact electrode 6D is separated from the common electrode part 6a.

In the case of the structure of FIG. 27B, the upper electrode 6 has a plurality of projecting portions 6b projecting in the -Z-axis direction and in which the longitudinal direction of the top surface extends in the X-axis direction and the projecting portions 6b are formed between the projecting portions 4b. Also, as in the lower electrode, the projecting portion 6b of the upper electrode constitutes a column aligned in the Y-axis direction and constitutes a plurality of columns (two columns). A groove recessed in the +Z-axis direction is formed between the projecting portions 6b and houses the projecting portion 4b. The common electrode part 6a serving as the base is generally rectangular, the contact portion 6c extends in the -X-axis direction from one end of the common electrode part 6a, and the lower contact electrode 6D is separated from the common electrode part 6a.

The case of the structure of FIG. 27C is the same as the case of the structure of FIG. 27B in that the upper electrode 6 has a plurality of projecting portions 6b projecting in the -Z-axis direction and in which the longitudinal direction of the top surface extends in the Y-axis direction and the plurality of projecting portions 6b are separated to be aligned in two columns in the Y-axis direction. The structure of FIG. 27C is only different from the structure of FIG. 27B in that a plurality of projecting portions 6b in which the top surface extends in the Y-axis direction are separately positioned in the gap between the above-described projecting portion columns.

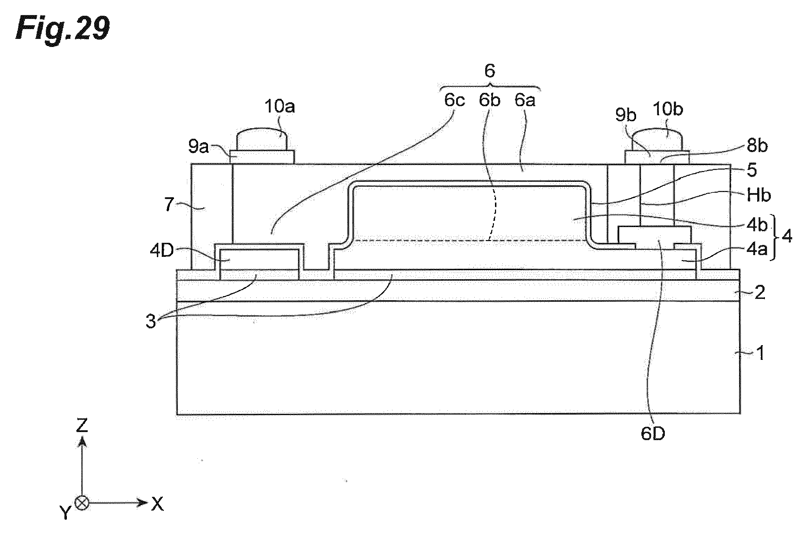

FIG. 29 is a diagram illustrating a vertical cross-sectional configuration of the thin film capacitor according to a modified embodiment.

The structure illustrated in FIG. 29 is a structure in which the thickness of the upper electrode 6 is thicker than that of the structure illustrated in FIG. 24 and the upper electrode 6 also serves as a first connection electrode and therefore the contact electrode and/or the under bump metal 9a are directly formed on the upper electrode 6 formed within the protective film 7. Other structures are the same as those illustrated in FIG. 24.

Next, the material of each element described above will be described.

The lower electrode 4 includes Cu as a main component. Also, the lower electrode 4 is assumed to be Cu of 100 (atm%). The upper electrode 6 also includes Cu as the main component. These can also be constituted of the same material or different materials. In this example, these are assumed to have the same material and the same physical properties. The substrate 1 is made of Si and the stress adjustment layer 2 is made of silicon nitride.

In this case, the Young's modulus $E_{SS}$ of the substrate 1, the Young's modulus $E_{SC}$ of the stress adjustment layer 2, and the Young's modulus $E_{LE}$ of the lower electrode 4 satisfy the following relational expressions.

Relational expressions:

$$E_{LE} < E_{SC}$$

$$E_{SS} < E_{SC}$$

According to this thin film capacitor, the deformation of the lower electrode 4 is suppressed because the stress adjustment layer 2 is harder than the softest lower electrode 4 and the substrate 1 for supporting the lower electrode 4 (has a higher Young's modulus) among the above-described three elements, and the damage associated with the deformation of the dielectric thin film 5 adjacent to the lower electrode and the characteristic deterioration associated with the damage can be suppressed.

The dielectric thin film 5 is made of $Al_2O_3$, but another dielectric material (insulating material) can be used. The Young's modulus of $Al_2O_3$ is 370. Cu, Si, SiNx, and $Al_2O_3$ are arranged in ascending order of Young's modulus. When the Young's modulus of the dielectric thin film is high and its damage is suppressed, the present invention is more effective. Characteristic data of each element is as shown in the chart of FIG. 7.

Also, Cu is used as an electrode material, but a metal material illustrated in FIG. 7 may be mixed with the electrode material. That is, one or more types selected from the group of metals consisting of Au, Ag, Al, Ni, Cr, Ti, and Ta may be mixed with Cu. Manufacturing can be simplified if the materials of the lower electrode and the upper electrode are the same, but these may be different.

Also, GaAs, SiC, Ge, or Ga can be used as a material constituting the substrate in addition to Si as illustrated in FIG. 7.

As illustrated in FIG. 7, SiNx, AlN, $SiO_2$, $ZrO_2$, glass, polyethylene, polystyrene, polyimide, polyethylene terephthalate (PET), or an epoxy resin can be used as the material of the dielectric thin film. Also, these dielectrics can be used as the material of the protective film.

Also, a linear expansion coefficient $\alpha_{SS}$ of the substrate 1, a linear expansion coefficient $\alpha_{SC}$ of the stress adjustment layer 2, and a linear expansion coefficient $\alpha_{LE}$ of the lower electrode 4 satisfy the following relational expressions.

Relational expressions:

$$\alpha_{SC} < \alpha_{LE}$$

$$\alpha_{SC} < \alpha_{SS}$$

In this case, because the linear expansion coefficient of the stress adjustment layer is small even when thermal expansion occurs in the substrate or the lower electrode, the deformation of the lower electrode due to a change in a temperature decreases due to the suppression of thermal expansion of the substrate or the lower electrode, the damage of the dielectric thin film adjacent to the substrate or the lower electrode, and the characteristic deterioration associated with the damage can be suppressed.

In the third thin film capacitor as well, it is preferable that a heat conductivity $\lambda_{SS}$ of the substrate, a heat conductivity $\lambda_{SC}$ of the stress adjustment layer, and a heat conductivity $\lambda_{LE}$ of the lower electrode satisfy the following relational expressions.

Relational expressions:

$$\lambda_{SC} < \lambda_{SS}$$

$$\lambda_{SC} < \lambda_{LE}$$

In this case, because the heat conductivity of the stress adjustment layer is small even when the change in the temperature occurs in the substrate or the lower electrode, the deformation of the lower electrode due to the change in the temperature decreases due to the suppression of the heat conduction of the substrate and the lower electrode and the suppression of the occurrence of linear expansion and the damage of the dielectric thin film adjacent to the substrate and the lower electrode and the characteristic deterioration according to the damage can be suppressed. In particular, the effect tends to be large in terms of the fact that the change in the temperature in a substrate having a relatively large volume does not affect the lower electrode.

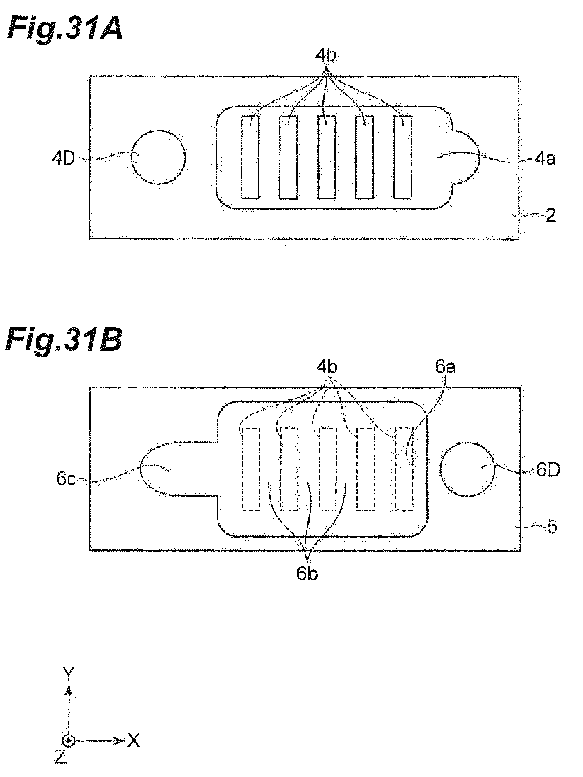

FIG. 31A is a plan view of a lower electrode and a dummy electrode in a comparative example. FIG. 31B is a plan view of an upper electrode and a lower contact electrode.

The thin film capacitor is different from the thin film capacitors illustrated in FIGS. 26A and 27A in that all the longitudinal directions of the top surfaces of the projecting portion 4b and the projecting portion 6b of each of structures of the lower electrode and the upper electrode are in the Y-axis direction and other structures are the same.

Also, a structure obtained by improving a shape of a projecting portion was also considered in addition to the comparative examples.

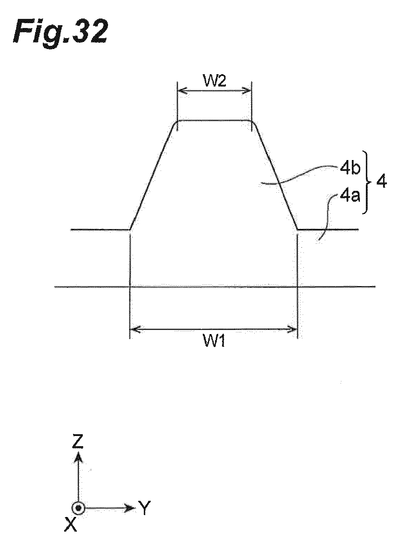

FIG. 32 is a diagram illustrating an example in which a vertical cross-sectional structure (which is the same as a structure of an upper electrode) in a YZ plane of the projecting portion of the lower electrode has a tapered shape.

In the projecting portion 4b of the lower electrode, the width in the Y-axis direction is narrowed in the direction (+Z axis direction) from the proximal end to the distal end. In this case, because it is possible to decrease mutual impedance occurring between a plurality of projecting portions of the lower electrode, the impedance decreases and the ESR also decreases. Therefore, the loss can be further reduced and the operation can be stable.

Also, when a ratio between a Y-axis direction width W1 of the proximal end of the projecting portion 4b of the lower electrode and a Y-axis direction width W2 of the distal end of the projecting portion 4b of the lower electrode is RW = W1/W2, the ratio RW satisfies the following relational expression.

$$1.2 \leq RW \leq 1.9$$

Also, when the corner portion of the projecting portion has the radius of curvature, the median of its arc is set as a reference position when the width W1 or W2 is defined. When RW is less than 1.2, the impedance increases, the current of an electrode surface is unlikely to flow, and there is room for improvement in the reduction of the ESR because the concentration of the high-frequency signal in the top surface edge portion of the above-described projecting portion is excessively large and it is difficult to decrease the mutual impedance between projecting portions of the lower electrode. When RW is greater than 1.9, a signal component tends to move between projecting portions of the lower electrode as in a planar thin film capacitor. Because impedance occurs due to this signal propagation in a horizontal direction, the ESR also decreases.

When a tapered shape is formed, the projecting portion 4b of the lower electrode is processed in FIG. 25E. The distal end of the projecting portion 4b is slightly rounded. In this process, the projecting portion 4b is formed within an opening pattern of a mask after the mask patterned by photolithography is formed on the flat common electrode part 4a. It is possible to use the plating or sputtering method in this formation, but the metal is assumed to be grown using the plating method here.

Next, a side surface of the projecting portion 4b is exposed by removing the mask including a resist using organic solvent or the like.

Thereafter, a process of etching all exposed surfaces of the projecting portion 4b is performed. For example, a tapered shape can be formed using a method (a sputtering method and a milling method) of rounding the corner portion of an outer edge of the top surface or the corner portion of the proximal end by causing a rare gas such as Ar to collide with the top surface or by performing dry etching or wet etching thereon.

Also, the metal can be etched with a suitable acid. For example, a sulfuric acid or hydrogen peroxide etching solution is well known as an etchant for copper, and the metal can be etched by merely sputtering metal atoms with a rare gas as dry etching using plasma or the like, but techniques of etching the metal while utilizing the oxidation of copper by employing a hydrocarbon gas or a halogen gas or incorporating oxygen therein are also well known.

(Experiment example)

Hereinafter, experiment examples (an embodiment and a comparative example) in the third type of invention will be described. The following experiments were performed.

(Experiment conditions)

The common electrode part 4a and the projecting portion 4b are made of Cu and grown by a plating method. In this etching, using a 5 wt% aqueous solution of ferric chloride and using alumina formed by an ALD method as the dielectric thin film 5 having a thickness of 140 nm, an upper electrode made of Cu was formed thereon by a sputtering method. Also, the thickness of the common electrode part 4a was set to 2 $\mu$m and the height of the projecting portion 4b was set to 8 $\mu$m. The pitch of the Y-axis direction of the uneven surface structure is 4 $\mu$m, the material of the protective film configured to cover the upper electrode is polyimide, and the plating of Ni and Au is performed on Cu for the connection electrode passing through the inside of the protective film, a contact electrode positioned at a termination end of the connection electrode, or the under bump metal. These electrodes were prepared using a plating method. The Y-axis direction length (width) of the manufactured thin film capacitor is 0.1 mm and the X-axis direction length (length) is 0.4 mm. Also, lengths between both ends in the X-axis direction of both the projecting portion 4b and the projecting portion 6b are 210 $\mu$m regardless of the presence/absence of separation.
Also, a process of tapering the projecting portion 4b was performed using a composite processing method of immersion into a 0.5 wt% aqueous solution of ferric chloride after Ar ion etching.

(Embodiment 1)

The thin film capacitor illustrated in FIG. 24 having the electrode structure illustrated in FIGS. 26B and 27B was manufactured, but the tapering process of FIG. 32 was not performed on the projecting portions of the lower electrode and the upper electrode and a tapering ratio RW = 1. The X-axis direction gap between the projecting portion columns is between 45% and 50% of the X-axis direction length of the projecting portion and the lower electrode of a region between the projecting portion columns is flat. Also, W1 = 1.7 $\mu$m and W2 = 1.7 $\mu$m.

(Embodiment 2)

The thin film capacitor illustrated in FIG. 24 having the electrode structure illustrated in FIGS. 26A and 27A was manufactured, but the tapering process of FIG. 32 was not performed on the projecting portions of the lower electrode and the upper electrode, and a tapering ratio RW = 1.

(Embodiment 3)

The thin film capacitor illustrated in FIG. 24 having the electrode structure illustrated in FIGS. 26A and 27A was manufactured, and the tapering process of FIG. 32 was performed on the projecting portions of the lower electrode and the upper electrode. A tapering ratio RW = 1.5. Also, W1 = 1.7 $\mu$m and W2 = 1.1 $\mu$m.

(Embodiment 4)

The thin film capacitor illustrated in FIG. 24 having the electrode structure illustrated in FIGS. 26A and 27A was manufactured, and the tapering process of FIG. 32 was performed on the projecting portions of the lower electrode and the upper electrode. A tapering ratio RW = 1.2. Also, W1 = 1.7 $\mu$m and W2 = 1.4 $\mu$m.

(Embodiment 5)

The thin film capacitor illustrated in FIG. 24 having the electrode structure illustrated in FIGS. 26A and 27A was manufactured, and the tapering process of FIG. 32 was performed on the projecting portions of the lower electrode and the upper electrode. A tapering ratio RW = 1.9. Also, W1 = 1.7 $\mu$m and W2 = 0.9 $\mu$m.

(Embodiment 6)

The thin film capacitor illustrated in FIG. 24 having the electrode structure illustrated in FIGS. 26A and 27A was manufactured, and the tapering process of FIG. 32 was performed on the projecting portions of the lower electrode and the upper electrode. A tapering ratio RW = 1.05. Also, W1 = 1.7 $\mu$m and W2 = 1.6 $\mu$m.

(Embodiment 7)

The thin film capacitor illustrated in FIG. 24 having the electrode structure illustrated in FIGS. 26A and 27A was manufactured, and the tapering process of FIG. 32 was performed on the projecting portions of the lower electrode and the upper electrode. A tapering ratio RW = 2.2. Also, W1 = 1.7 $\mu$m and W2 = 0.8 $\mu$m.

(Experiment results: third type of invention)

Embodiment 1: Q value = 1050 (center separation type of projecting portion: RW = 1)

Embodiment 2: Q value = 1220 (continuation type of projecting portion: RW = 1)

Embodiment 3: Q value = 1450 (tapered shape of projecting portion: RW = 1.5)

Embodiment 4: Q value = 1370 (tapered shape of projecting portion: RW = 1.2)

Embodiment 5: Q value = 1320 (tapered shape of projecting portion: RW = 1.9)

Embodiment 6: Q value = 1255 (tapered shape of projecting portion: RW = 1.05)

Embodiment 7: Q value = 1230 (tapered shape of projecting portion: RW = 2.2)

Comparative example 1: Q value = 164 (RW = 1 in the type of FIG. 31 and other details are the same as those of embodiment 2)

Also, the Q value was measured at 100 MHz. The Q value increases as the ESR decreases and is excellent from a point of view of loss and stability.

Embodiments 1 to 7 have higher Q values than comparative example 1, and embodiment 2 having a continuous projecting portion has a higher Q value than embodiment 1 having a separated projecting portion. Further, embodiments 3 to 7 having a tapered shape have higher Q values than embodiment 1 and embodiment 2. Further, embodiments 3 to 5 in which the ratio RW of the tapered shape is greater than or equal to 1.2 and less than or equal to 1.9 have higher Q values than embodiments 6 and 7 outside of this range.

As described above, the above-described thin film capacitor includes: a substrate 1; a stress adjustment layer 2 (insulating layer) formed on a main surface of the substrate 1; a lower electrode 4 formed on the stress adjustment layer 2; a dielectric thin film 5 configured to cover the lower electrode 4; an upper electrode 6 formed on the dielectric thin film 5; a first terminal 8b provided in the lower electrode 4; and a second terminal 8a provided in the upper electrode 6, wherein, when an XYZ three-dimensional coordinate system is set, the main surface of the substrate is an XY plane, and a direction in which the first terminal 8b and the second terminal 8a are connected is designated as an X-axis, the lower electrode 4 has an uneven surface structure and a longitudinal direction of a top surface of the projecting portion 4b of the uneven surface structure is in the X-axis direction.

According to this thin film capacitor, it is possible to increase the capacitance per unit area because the lower electrode has an uneven surface structure. When a bias voltage is applied between the first terminal 8b and the second terminal 8a, charge is accumulated in the thin film capacitor. When the applied voltage is an alternating current voltage, an alternating current flows between the terminals. When the ESR increases, the loss of power based on resistance may occur and the circuit operation may be unstable. Therefore, it is preferable to decrease the ESR. When the ESR decreases, the Q value of the thin film capacitor becomes high.

In this thin film capacitor, the longitudinal direction of the top surface of the projecting portion of the uneven surface structure is in the X-axis direction (a direction connected between the terminals). This structure has lower ESR than when the longitudinal direction of the top surface extends along the Y axis. Therefore, according to the thin film capacitor, the ESR becomes low, the loss can be reduced, and the operation can be stable.

Also, when the width in the Y-axis direction is narrowed in a direction from the proximal end to the distal end in the projecting portion of the lower electrode, the improvement of the Q value (decrease of ESR) is observed. In particular, when the tapering ratio satisfies $1.2 \leq RW \leq 1.9$, this improvement effect is significant.

As described above, it is possible to increase capacitance because the thin film capacitor having an uneven surface structure is a structure in which an area opposite to the electrode in a unit volume increases. On the other hand, because the electrode is subdivided, the strength is degraded, a mechanical force generated by a temperature increase during mounting or an environment during actual use is transferred to a dielectric layer and the dielectric layer may be destroyed. In this embodiment, this destruction is suppressed. A lower electrode in which the shape of the vertical cross section is a comb tooth or slit shape or a lower electrode in which the shape of the vertical cross section is a shape including a pin or hole can be used as the uneven surface structure of the lower electrode, and the structures of the lower electrode and the upper electrode can also be replaced with each other.

As described above, it is possible to suppress stress accumulation for the dielectric thin film and suppress the characteristic deterioration by satisfying the above-described predetermined conditions. Also, it is possible to provide a thin film capacitor having small loss and high stability.

As described above, the lower electrode 4 can have various types of uneven surface structures. The upper electrode 6 can also have various types of uneven surface structures. A projecting portion projecting to the lower electrode side of the upper electrode 6 can be positioned in the gap between projecting portions of the lower electrode 4. The lower electrode 4 contains Cu as the main component. The Young's moduli of the substrate 1, the stress adjustment layer 2, and the lower electrode 4 have a specific relation. In addition, corner portions of the radii R1 of curvature positioned inside the projecting portion 4b have a specific relation. Any elements described above can be used in combination and it is possible to suppress the decrease of mechanical strength, the occurrence of loss, and/or instability.

**Claims**

**1.** A thin film capacitor comprising:

a substrate;

a stress adjustment layer formed on a main surface of the substrate;

a lower electrode formed on the stress adjustment layer;

a dielectric thin film configured to cover the lower electrode; and

an upper electrode formed on the dielectric thin film,

wherein the lower electrode has an uneven surface structure of a vertical cross section in a thickness direction of the substrate,

wherein the upper electrode has an uneven surface structure of a vertical cross section in a thickness direction of the substrate,

wherein a projecting portion of the upper electrode projecting to a lower electrode side is positioned in a gap between projecting portions of the lower electrode,

wherein the lower electrode includes Cu as a main component, and

wherein a Young's modulus $E_{SS}$ of the substrate, a Young's modulus $E_{SC}$ of the stress adjustment layer, and a Young's modulus $E_{LE}$ of the lower electrode satisfy the relational expressions $E_{LE} < E_{SC}$ and $Ess < E_{SC}$.

2. The thin film capacitor according to claim 1, wherein a linear expansion coefficient $\alpha_{SS}$ of the substrate, a linear expansion coefficient $\alpha_{SC}$ of the stress adjustment layer, and a linear expansion coefficient $\alpha_{LE}$ of the lower electrode satisfy the relational expressions $\alpha_{SC} < \alpha_{LE}$ and $\alpha_{SC} < \alpha_{SS}$.

3. The thin film capacitor according to claim 1, wherein a heat conductivity $\lambda_{SS}$ of the substrate, a heat conductivity $\lambda_{SC}$ of the stress adjustment layer, and a heat conductivity $\lambda_{LE}$ of the lower electrode satisfy the relational expressions $\lambda_{SC} < \lambda_{SS}$ and $\lambda_{SC} < \lambda_{LE}$.

4. The thin film capacitor according to claim 1, wherein the lower electrode includes a common electrode part extending in parallel to a main surface of the substrate; and a plurality of projecting portions extending to project away from the substrate from the common electrode part, wherein the thin film capacitor includes:

a protective film configured to cover the upper electrode;

a dummy electrode formed on the stress adjustment layer; and

a lower contact electrode formed on the common electrode part of the lower electrode,

wherein the dielectric thin film, the upper electrode, and a first connection electrode are positioned on the dummy electrode,

wherein the lower contact electrode in contact with the common electrode part and a second connection electrode are positioned on the common electrode part of the lower electrode via an opening provided in the dielectric thin film,

wherein the dummy electrode has the same thickness as the common electrode part of the lower electrode,

wherein the first connection electrode is positioned within a first contact hole provided in the protective film, and

wherein the second connection electrode is positioned within a second contact hole provided in the protective film.

5. A thin film capacitor comprising:

a substrate;

an insulating layer formed on a main surface of the substrate;

a lower electrode formed on the insulating layer;

a dielectric thin film configured to cover the lower electrode; and

an upper electrode formed on the dielectric thin film,

wherein the lower electrode has an uneven surface structure of a vertical cross section in a thickness direction of the substrate,

wherein the upper electrode has an uneven surface structure of a vertical cross section in a thickness direction of the substrate,

wherein a projecting portion of the upper electrode projecting to a lower electrode side is positioned in a gap between projecting portions of the lower electrode,

wherein, when an XYZ three-dimensional coordinate system is set, the main surface is an XY plane, and a direction in which a plurality of projecting portions of the lower electrode are arranged is designated as an X-axis direction, a distal end of the projecting portion of the lower electrode within the XZ plane has a corner portion of a radius R1 of curvature in which a center of curvature is positioned inside the projecting portion, and

wherein the radius R1 of curvature and a thickness td of the dielectric thin film satisfy the relational expression $0.4 \times td \leq R1 \leq 20 \times td$.

6. The thin film capacitor according to claim 5, wherein a proximal end of the projecting portion of the lower electrode within the XZ plane has a corner portion of a radius R2 of curvature in which a center of curvature is positioned outside the projecting portion, and

wherein the radius R2 of curvature and the thickness td of the dielectric thin film satisfy the relational expression $0.4 \times td \leq R2 \leq 20 \times td$.

**7.** The thin film capacitor according to claim 5, wherein the distal end of the projecting portion of the lower electrode within the YZ plane has a corner portion of a radius R3 of curvature in which a center of curvature is positioned inside the projecting portion, and
wherein the radius R3 of curvature and the thickness td of the dielectric thin film satisfy the relational expression $0.4 \times td \leq R3 \leq 20xtd$.

**8.** The thin film capacitor according to claim 5, wherein the distal end of the projecting portion of the lower electrode within the YZ plane has a corner portion of a radius R4 of curvature in which a center of curvature is positioned outside the projecting portion, and
wherein the radius R4 of curvature and the thickness td of the dielectric thin film satisfy the relational expression $0.4 \times td \leq R4 \leq 20xtd$.

**9.** The thin film capacitor according to claim 5, wherein the relational expression $0.5 \times td \leq R1 \leq 10 \times td$ is satisfied.

**10.** The thin film capacitor according to claim 5, wherein the relational expression $0.5 \times td \leq R2 \leq 10 \times td$ is satisfied.

**11.** The thin film capacitor according to claim 5, wherein the insulating layer is a stress adjustment layer, and
wherein a Young's modulus of the stress adjustment layer is greater than a Young's modulus of the substrate and greater than a Young's modulus of the lower electrode.

**12.** A thin film capacitor comprising:

a substrate;
an insulating layer formed on a main surface of the substrate;
a lower electrode formed on the insulating layer;
a dielectric thin film configured to cover the lower electrode;
an upper electrode formed on the dielectric thin film;
a first terminal provided in the lower electrode; and
a second terminal provided in the upper electrode,

wherein, when an XYZ three-dimensional coordinate system is set, the main surface is an XY plane, and a direction in which the first terminal and the second terminal are connected is designated as an X-axis, the lower electrode has an uneven surface structure and a longitudinal direction of a top surface of the projecting portion of the uneven surface structure is in the X-axis direction.

**13.** The thin film capacitor according to claim 12, wherein the width of the projecting portion of the lower electrode in a Y-axis direction narrows from a proximal end to a distal end.

**14.** The thin film capacitor according to claim 13, wherein, when a ratio between a Y-axis direction width W1 of the proximal end of the projecting portion of the lower electrode and a Y-axis direction width W2 of the distal end of the projecting portion of the lower electrode is RW = W1/W2, the ratio RW satisfies the relational expression $1.2 \leq RW \leq 1.9$.

*Fig.1*

EP 3 076 450 A1

Fig.2F

Fig.2G

Fig.2H

Fig.2I

Fig.2A

Fig.2B

Fig.2C

Fig.2D

Fig.2E

*Fig.3A*

4b

4D

4a

2

*Fig.3B*

4b

4D

4a

2

*Fig.3C*

4b

4D

4a

2

Y

X

Z

## Fig.4A

4b    6a

6c    6D

5

6b

## Fig.4B

4b    6b

6c    6D

5

6a

## Fig.4C

4b    6b

6c    6D

5

6a

Y
X
Z

# Fig.5

*Fig.6*

## Fig.7

| | Linear expansion coefficient (thermal expansion rate) [$\mu$ m/mK] Room temperature to 300°C | Heat conductivity [W/mK] Room temperature to 300°C | Young's modulus [GPa] Room temperature to 300°C |
|---|---|---|---|
| Au | 14.2 | 318 | 79 |
| Ag | 18.9 | 174 | 83 |
| Al | 23.1 | 237 | 70 |
| Cu | 16.5 | 401 | 110~128 |
| Ni | 13.4 | 90.9 | 200 |
| Cr | 4.9 | 93.9 | 279 |
| Ti | 8.6 | 21.9 | 116 |
| Ta | 6.3 | 57.5 | 186 |
| | | | |
| Si | 2.6 | 149 | 185 |
| Ge | 6 | 60.2 | 103 |
| Ga | 1.2 | 40.6 | 9.8 |
| | | | |
| SiNx | 2.6 | 20 | 290 |
| Al2O3 | 7.2 | 32 | 370 |
| AlN | 4.6 | 150 | 320 |
| GaAs | 6.86 | 0.46 | 83 |
| SiC | 4.4 | 60 | 430 |
| ZrO2 | 10.5 | 3 | 200 |
| | | | |
| Glass | 8~10 | 1 | 80 |
| SiO2 | 0.5 | 1~8 | 72 |
| | | | |
| Polyethylene | 100~200 | 0.41 | 0.7 |
| Polystyrene | 50~80 | 0.02 | 3.2 |
| Polyimide | 54 | 0.3 | 3~7 |
| PET | 70 | 0.2~0.3 | 2.7 |
| Epoxy | 62 | 0.21 | 2.6~3 |

## Fig.8

| | Young's modulus | | | | | | Presence/absence of establishment of relational expressions $E_{LE} < E_{SC}$ $E_{SS} < E_{SC}$ |
|---|---|---|---|---|---|---|---|
| | Substrate | | Stress adjustment layer | | Lower electrode | | |
| | Material | Young's modulus $E_{SS}$ | Material | Young's modulus $E_{SC}$ | Material | Young's modulus $E_{LE}$ | |
| Embodiment 1 | Si | 185 | SiNx | 290 | Cu | 110-128 | ○ |
| Embodiment 2 | Si | 185 | SiNx | 290 | Al | 70 | ○ |
| Embodiment 3 | Si | 185 | SiNx | 290 | Ni | 200 | ○ |
| Embodiment 4 | Si | 185 | $Al_2O_3$ | 370 | Cu | 110-128 | ○ |
| Embodiment 5 | Si | 185 | $Al_2O_3$ | 370 | Al | 70 | ○ |
| Embodiment 6 | Si | 185 | $ZrO_2$ | 200 | Cu | 110-128 | ○ |
| Embodiment 7 | Si | 185 | $SiO_2$ | 72 | Al | 70 | ○ |
| Embodiment 8 | $ZrO_2$ | 200 | AlN | 320 | Cu | 110-128 | ○ |
| Embodiment 9 | Si | 185 | AlN | 320 | Ni | 200 | ○ |
| Comparative example 1 | Si | 185 | $ZrO_2$ | 200 | Ni | 200 | × |
| Comparative example 2 | Si | 185 | $SiO_2$ | 72 | Cu | 110-128 | × |
| Comparative example 3 | $Al_2O_3$ | 370 | $SiO_2$ | 72 | Cu | 110-128 | × |
| Comparative example 4 | PET | 2.7 | $SiO_2$ | 72 | Cu | 110-128 | × |
| Comparative example 5 | Si | 185 | Polyimide | 3~7 | Cu | 110-128 | × |

**Fig.9**

| | Linear expansion coefficient | | | | | | Presence/absence of establishment of relational expressions $\alpha_{SC} < \alpha_{LE}$ $\alpha_{SC} < \alpha_{SS}$ |
| | Substrate | | Stress adjustment layer | | Lower electrode | | |
| | Material | Linear expansion coefficient $\alpha_{SS}$ | Material | Linear expansion coefficient $\alpha_{SC}$ | Material | Linear expansion coefficient $\alpha_{LE}$ | |
|---|---|---|---|---|---|---|---|
| Embodiment 1 | Si | 2.6 | SiNx | 2.6 | Cu | 16.5 | O |
| Embodiment 2 | Si | 2.6 | SiNx | 2.6 | Al | 23.1 | O |
| Embodiment 3 | Si | 2.6 | SiNx | 2.6 | Ni | 13.4 | O |
| Embodiment 4 | Si | 2.6 | $Al_2O_3$ | 7.2 | Cu | 16.5 | O |
| Embodiment 5 | Si | 2.6 | $Al_2O_3$ | 7.2 | Al | 23.1 | O |
| Embodiment 6 | Si | 2.6 | $ZrO_2$ | 10.5 | Cu | 16.5 | O |
| Embodiment 7 | Si | 2.6 | $SiO_2$ | 0.5 | Al | 23.1 | O |
| Embodiment 8 | $ZrO_2$ | 10.5 | AlN | 4.6 | Cu | 16.5 | O |
| Embodiment 9 | Si | 2.6 | AlN | 4.6 | Ni | 13.4 | × |
| Comparative example 1 | Si | 2.6 | $ZrO_2$ | 10.5 | Ni | 13.4 | O |
| Comparative example 2 | Si | 2.6 | $SiO_2$ | 0.5 | Cu | 16.5 | O |
| Comparative example 3 | $Al_2O_3$ | 7.2 | $SiO_2$ | 0.5 | Cu | 16.5 | O |
| Comparative example 4 | PET | 70 | $SiO_2$ | 0.5 | Cu | 16.5 | O |
| Comparative example 5 | Si | 2.6 | Polyimide | 54 | Cu | 16.5 | × |

**Fig.10**

| | Heat conductivity | | | | | | Presence/absence of establishment of relational expressions $\lambda_{SC} < \lambda_{LE}$ $\lambda_{SC} < \lambda_{SS}$ |
|---|---|---|---|---|---|---|---|
| | Substrate | | Stress adjustment layer | | Lower electrode | | |
| | Material | Heat conductivity $\lambda_{SS}$ | Material | Heat conductivity $\lambda_{SC}$ | Material | Heat conductivity $\lambda_{LE}$ | |
| Embodiment 1 | Si | 149 | SiNx | 20 | Cu | 401 | O |
| Embodiment 2 | Si | 149 | SiNx | 20 | Al | 237 | O |
| Embodiment 3 | Si | 149 | SiNx | 20 | Ni | 90.9 | O |
| Embodiment 4 | Si | 149 | $Al_2O_3$ | 32 | Cu | 401 | O |
| Embodiment 5 | Si | 149 | $Al_2O_3$ | 32 | Al | 237 | O |
| Embodiment 6 | Si | 149 | $ZrO_2$ | 3 | Cu | 401 | O |
| Embodiment 7 | Si | 149 | $SiO_2$ | 1~8 | Al | 237 | O |
| Embodiment 8 | $ZrO_2$ | 3 | AlN | 150 | Cu | 401 | × |
| Embodiment 9 | Si | 149 | AlN | 150 | Ni | 90.9 | × |
| Comparative example 1 | Si | 149 | $ZrO_2$ | 3 | Ni | 90.9 | O |
| Comparative example 2 | Si | 149 | $SiO_2$ | 1~8 | Cu | 401 | O |
| Comparative example 3 | $Al_2O_3$ | 32 | $SiO_2$ | 1~8 | Cu | 401 | O |
| Comparative example 4 | PET | 0.2~0.3 | $SiO_2$ | 1~8 | Cu | 401 | × |
| Comparative example 5 | Si | 149 | Polyimide | 0.3 | Cu | 401 | O |

## Fig.11

| | Number of remaining pieces after 30 V is applied<br>(Experiment conditions)<br>·Number of samples = 1000<br>·Humidity＝85%<br>·Temperature＝80°C<br>·Drive voltage ＝30V |
|---|---|
| Embodiment 1 | 983 |
| Embodiment 2 | 956 |
| Embodiment 3 | 970 |
| Embodiment 4 | 898 |
| Embodiment 5 | 908 |
| Embodiment 6 | 913 |
| Embodiment 7 | 943 |
| Embodiment 8 | 622 |
| Embodiment 9 | 570 |
| Comparative example 1 | 201 |
| Comparative example 2 | 128 |
| Comparative example 3 | 108 |
| Comparative example 4 | 89 |
| Comparative example 5 | 63 |

*Fig.12*

EP 3 076 450 A1

Fig.13A
Fig.13B
Fig.13C
Fig.13D
Fig.13E
Fig.13F
Fig.13G
Fig.13H
Fig.13I

*Fig.14A*

4b

4D

4a

2

*Fig.14B*

4b

4D

4a

2

*Fig.14C*

4b

4D

4a

2

Y

X

Z

*Fig.15A*

*Fig.15B*

*Fig.15C*

# Fig.16

Fig.17

EP 3 076 450 A1

EP 3 076 450 A1

*Fig.18A*

*Fig.18B*

*Fig.18C*

**Fig.19**

EP 3 076 450 A1

EP 3 076 450 A1

*Fig.20A*

*Fig.20B*

*Fig.20C*

Fig.21

*Fig.22*

# Fig.23

| | Shape of corner portion | | Evaluation result |
|---|---|---|---|
| | Radius of curvature/td | Corner portion formation position | Number of remaining pieces after 30 V is applied (Experiment conditions) · Number of samples=1000 ·Humidity=85% ·Temperature=80℃ ·Drive voltage=30V |
| Comparative example 1 | 0.14 | TYPE1 | Less than 500 |
| Comparative example 2 | 0.35 | TYPE1 | Less than 500 |
| Embodiment 1 | 0.4 | TYPE1 | 672 |
| Embodiment 2 | 0.45 | TYPE1 | 695 |
| Embodiment 3 | 0.4 | TYPE2 | 721 |
| Embodiment 4 | 0.45 | TYPE2 | 737 |
| Embodiment 5 | 0.5 | TYPE1 | 760 |
| Embodiment 6 | 0.5 | TYPE2 | 787 |
| Embodiment 7 | 1.2 | TYPE1 | 833 |
| Embodiment 8 | 1.2 | TYPE2 | 867 |
| Embodiment 9 | 3.5 | TYPE1 | 945 |
| Embodiment 10 | 3.5 | TYPE2 | 978 |
| Embodiment 11 | 5.2 | TYPE1 | 941 |
| Embodiment 12 | 5.2 | TYPE2 | 972 |
| Embodiment 13 | 8.4 | TYPE1 | 806 |
| Embodiment 14 | 8.4 | TYPE2 | 834 |
| Embodiment 15 | 10.9 | TYPE1 | 764 |
| Embodiment 16 | 10.9 | TYPE2 | 795 |
| Embodiment 17 | 12.1 | TYPE2 | 756 |
| Embodiment 18 | 18.5 | TYPE2 | 721 |
| Embodiment 19 | 20.6 | TYPE2 | 708 |
| Embodiment 20 | 12.1 | TYPE1 | 678 |
| Embodiment 21 | 18.5 | TYPE1 | 642 |
| Embodiment 22 | 20.6 | TYPE1 | 619 |
| Comparative example 3 | 20.5 | TYPE1 | Less than 500 |
| Comparative example 4 | 24.3 | TYPE1 | Less than 500 |

EP 3 076 450 A1

**Fig.24**

*Fig.25A*

1

*Fig.25B*

2
1

*Fig.25C*

4a
3
2
1

*Fig.25D*

4D
4a
3
2
1

*Fig.25E*

4D
4b
4a
2
1

Z
Y ⊗ → X

*Fig.25F*

5
4
2
1

*Fig.25G*

5   H
2
1

*Fig.25H*

6
5   6D
4a
2
1

*Fig.25I*

10a   6   10b  9b
9a   7   6c 6b 6a
8a   8b
Ha   5
4D   Hb   4b
4a   } 4
3   2
1
6D

EP 3 076 450 A1

*Fig.26A*

*Fig.26B*

*Fig.26C*

## Fig.27A

## Fig.27B

## Fig.27C

# Fig.28

EP 3 076 450 A1

*Fig.29*

## Fig.30



# Fig.31A

4b

4D

4a

2

# Fig.31B

4b

6a

6c

6D

5

6b

Y

Z

X

# *Fig.32*

Europäisches
Patentamt

European
Patent Office

Office européen
des brevets

**EUROPEAN SEARCH REPORT**

Application Number

EP 16 16 3266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 436 787 B1 (SHIH WONG-CHENG [TW] ET AL) 20 August 2002 (2002-08-20) | 1-3 | INV.<br>H01L49/02 |
| A | * figures 1-3 *<br>* column 2, paragraph 27 - column 3, paragraph 65 * | 4 | |
| A | US 2007/235787 A1 (NAGANO YOSHIHISA [JP] ET AL) 11 October 2007 (2007-10-11)<br>* figures 1-7 *<br>* paragraphs [0033] - [0065] * | 4,11 | |
| X | US 2006/006447 A1 (KIM HYUN-HO [KR] ET AL) 12 January 2006 (2006-01-12) | 5-10, 12-14 | |
| A | * figure 10 *<br>* paragraphs [0002] - [0013] *<br>* paragraphs [0021] - [0059] * | 4,11 | |

TECHNICAL FIELDS
SEARCHED      (IPC)

H01L

The present search report has been drawn up for all claims

| Place of search | Date of completion of the search | Examiner |
|---|---|---|
| Berlin | 29 July 2016 | Giesen, Fabian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 16 16 3266

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2016

| Patent document cited in search report | | Publication date | Patent family member(s) | | Publication date |
|---|---|---|---|---|---|
| US 6436787 | B1 | 20-08-2002 | NONE | | |
| US 2007235787 | A1 | 11-10-2007 | JP | 2006339498 A | 14-12-2006 |
| | | | US | 2007235787 A1 | 11-10-2007 |
| US 2006006447 | A1 | 12-01-2006 | KR | 20060005167 A | 17-01-2006 |
| | | | US | 2006006447 A1 | 12-01-2006 |

EPO FORM P0459

For more details about this annex : see Official Journal of the European Patent Office, No. 12/82

**EP 3 076 450 A1**

**REFERENCES CITED IN THE DESCRIPTION**

**Patent documents cited in the description**

- JP 2002026266 A
- US 6740922 B
- JP H6325970 B